(19) Europäisches Patentamt / European Patent Office / Office européen des brevets

(11) **EP 1 172 820 B1**

(12) **FASCICULE DE BREVET EUROPEEN**

(45) Date de publication et mention
de la délivrance du brevet:
**09.04.2008 Bulletin 2008/15**

(51) Int Cl.:
***G11C 7/10*** *(2006.01)*

(21) Numéro de dépôt: **01102475.9**

(22) Date de dépôt: **05.02.2001**

(54) **Mémoire série programmable et effacable électriquement à lecture par anticipation**

Programmierbarer und elektrisch löschbarer serieller auslesbarer Speicher durch Vorempfang

Programmable and electrically erasable serial readout memory by anticipation

(84) Etats contractants désignés:
**DE FR GB IT**

(30) Priorité: **28.02.2000 FR 0002449**

(43) Date de publication de la demande:
**16.01.2002 Bulletin 2002/03**

(73) Titulaire: **STMicroelectronics SA**
**F-92120 Montrouge (FR)**

(72) Inventeurs:
• **Zink, Sébastien**
**13086 Aix en Provence (FR)**

• **Cavaleri, Paola**
**13790 Rousset (FR)**
• **Leconte, Bruno**
**13790 Rousset (FR)**

(74) Mandataire: **Marchand, André**
**OMNIPAT,**
**24 Place des Martyrs de la Résistance**
**13100 Aix-en-Provence (FR)**

(56) Documents cités:
**WO-A-99/59154     US-A- 4 723 228**
**US-A- 4 797 858**

**Description**

La présente invention concerne les mémoires programmables et effaçables électriquement, notamment les mémoires EEPROM et les mémoires FLASH (FLASH-EEPROM).

La présente invention concerne plus particulièrement un procédé de lecture d'un mot binaire dans une mémoire à entrée et sortie série, comprenant une étape de lecture de données dans la mémoire sur réception d'une adresse partielle de lecture à laquelle il manque N bits de poids faible pour former une adresse complète.

Dans le brevet EP 712 133, représentant l'état de l'art le plus proche, la demanderesse a déjà exposé le problème rencontré avec les mémoires intégrées à accès série, tenant dans la quasi-impossibilité d'adapter la vitesse de lecture de ces mémoires aux cadences imposées par les bus série de type synchrone.

Rappelons en effet que le temps Tr conféré pour la lecture d'un mot binaire dans une mémoire à accès série s'étend entre l'instant où le dernier bit d'adresse est reçu par la mémoire et l'instant où le premier bit du mot désigné par cette adresse est émis par la mémoire. La lecture d'un bit d'adresse s'effectuant généralement au milieu d'une période d'horloge, et l'émission d'un bit de donnée s'effectuant au commencement d'une période d'horloge, le temps Tr est au minimum égal à une demi-période d'horloge. En fait, le temps Tr est de l'ordre de 1,5 périodes d'horloge avec un bus du type Microwire ou I2C (une pause d'un cycle d'horloge étant accordée entre la réception du dernier bit d'adresse et l'émission du premier bit du mot lu) et est de l'ordre de 0,5 période d'horloge avec un bus de type SPI, qui constitue le pire cas en ce qui concerne l'exigence de rapidité de lecture des mémoires.

Pendant le temps Tr, l'adresse reçue doit être appliquée au décodeur d'adresse de la mémoire, le mot désigné par l'adresse reçue doit être lu, le mot lu doit être chargé dans un registre de sortie à entrée parallèle et sortie série, et un signal de décalage doit être appliqué au registre de sortie pour que le premier bit du mot lu soit émis.

En pratique, le problème mentionné ci-dessus est dû au fait que la fréquence d'horloge des bus série n'a cessé d'augmenter ces dernières années avec l'évolution des technologies. Cette fréquence était généralement de l'ordre de 1 MHz il y a une dizaine d'années, soit une période d'horloge de l'ordre de la microseconde qui conférait un temps de lecture Tr de l'ordre de 0,5 microseconde dans le pire cas (bus SPI). Elle est fréquemment de l'ordre de 20 MHz à l'heure actuelle, soit une période d'horloge de 50 nanosecondes et un temps de lecture Tr très court de l'ordre de 25 nanosecondes.

Une tel temps de lecture Tr dépasse les possibilités de nombreuses mémoires EEPROM ou FLASH, malgré la prévision de circuits de lecture rapides.

Pour pallier cet inconvénient, le brevet EP 712 133 décrit un procédé de lecture consistant à déclencher une opération de lecture avant que tous les bits d'adresse ne soient reçus. Les bits d'adresse étant reçus au rythme du signal d'horloge, le gain de temps est égal à la période du signal d'horloge multipliée par le nombre N de bits d'adresse anticipés.

Bien que ce procédé soit, en soi, entièrement satisfaisant, il nécessite de lire simultanément M mots binaires ayant la même adresse partielle, M étant égal à $2^N$. Il est ainsi nécessaire de prévoir dans une mémoire à lecture par anticipation un nombre de circuits de lecture ("sense amplifier") plus important que dans une mémoire conventionnelle. Par exemple, il faut prévoir seize circuits de lecture au lieu de huit pour une lecture par anticipation de deux octets (N=1, M=2), trente-deux circuits de lecture au lieu de huit pour une lecture anticipée de quatre octets (N=2, M=4), etc..

Or, de tels circuits de lecture sont complexes et occupent une surface de silicium non négligeable. Pour fixer les idées, un circuit de lecture rapide occupe une surface de silicium représentant environ 1000 cellules mémoire. Le fait de doubler voire de quadrupler le nombre de circuits de lecture se fait au détriment de la compacité de la mémoire, la surface perdue représentant 8000 à 24000 cellules mémoires.

La présente invention vise à pallier cet inconvénient.

Plus particulièrement, un objectif de la présente invention est de prévoir un procédé de lecture par anticipation pouvant être mis en oeuvre sans démultiplier le nombre de circuits de lecture.

Un autre objectif de la présente invention est de prévoir des architectures de mémoire EEPROM et de mémoire FLASH permettant de mettre en oeuvre un tel procédé.

Pour atteindre ces objectifs, la présente invention prévoit un procédé de lecture d'un mot binaire dans une mémoire à entrée et sortie série, comprenant une première étape de lecture de données dans la mémoire sur réception série d'une adresse partielle de lecture à laquelle il manque N bits de poids faible pour former une adresse complète, dans lequel la première étape de lecture comprend les étapes consistant à : lire simultanément les P premiers bits de M mots de la mémoire ayant la même adresse partielle ; lorsque l'adresse complète est reçue, sélectionner les P premiers bits du mot désigné par l'adresse complète et délivrer ces bits sur la sortie série de la mémoire ; et comprenant une seconde étape de lecture consistant à lire P bits suivants du mot désigné par l'adresse complète pendant la délivrance de P bits précédents et délivrer les P bits suivants sur la sortie série de la mémoire lorsque les P bits précédents sont délivrés.

Selon un mode de réalisation, la lecture de P bits suivants est effectuée comme la lecture des P premiers bits, en lisant simultanément P bits suivants des M mots de la mémoire ayant la même adresse partielle et en sélectionnant les P bits suivants du mot désigné par l'adresse complète.

Selon un mode de réalisation applicable à une mémoire dans laquelle les cellules mémoire sont agencées en lignes de mot et en lignes de bit et les lignes de bit agencées en colonnes, le procédé comprend une étape consistant à prévoir dans la mémoire : un décodeur d'adresse agencé pour sélectionner simultanément, après application au décodeur d'une adresse complète, P lignes de bit de M colonnes différentes, et un bus d'interconnexion agencé pour relier chacune des P lignes de bit sélectionnées à un circuit de lecture.

Selon un mode de réalisation, l'étape de lecture est effectuée en appliquant au décodeur l'adresse partielle reçue, et en balayant sur les entrées d'adresse de poids faible du décodeur les $2^N$ combinaisons possibles des N derniers bits d'adresse.

Selon un mode de réalisation applicable à une mémoire comprenant des cellules agencées en lignes de mot et en lignes de bit, une ligne de mot formant une page mémoire, le procédé comprend une étape préliminaire consistant à enregistrer M mots de même adresse partielle dans M sous-pages adjacentes d'une page mémoire, enregistrer chaque mot dans P groupes adjacents de cellules comprenant chacun K/P sous-groupes adjacents de cellules, K étant le nombre de bits de chaque mot, et enregistrer des bits de rang j et j+1 d'un mot dans des groupes de cellules adjacents, et des bits de rang j et j+P d'un mot dans des sous-groupes de cellules adjacents, de telle sorte que les mots sont repliés dans les sous-pages.

Selon un mode de réalisation, l'étape de lecture comprend une étape de présélection consistant à sélectionner simultanément en lecture, dans chaque groupe de cellules de chaque sous-page de la mémoire, toutes les cellules contenant les bits des M mots ayant la même adresse partielle, et une étape de sélection consistant à connecter à un circuit de lecture les cellules contenant l'un des P bits visés de chacun des M mots.

Selon un mode de réalisation, les P premiers bits de chacun des mots lus simultanément dans la mémoire sont des bits de poids fort.

La présente invention concerne également une mémoire en circuit intégré à entrée et sortie série, comprenant des moyens pour, sur réception série d'une adresse partielle de lecture à laquelle il manque N bits de poids faible pour former une adresse complète : lire simultanément les P premiers bits de M mots de la mémoire ayant la même adresse partielle ; lorsque l'adresse complète est reçue, sélectionner les P premiers bits du mot désigné par l'adresse complète et délivrer ces bits sur la sortie série ; lire P bits suivants du mot désigné par l'adresse complète pendant la délivrance des P premiers bits et délivrer ces bits sur la sortie série lorsque les P premiers bits sont délivrés.

Selon un mode de réalisation, la mémoire comprend des moyens de sélection d'un groupe de P bits parmi M groupes de P bits lus simultanément, recevant sur une entrée de commande les N bits de poids faible de l'adresse complète.

Selon un mode de réalisation, la mémoire comprend des cellules mémoire agencées en lignes de mot et en lignes de bit, les lignes de bit étant agencées en colonnes, un décodeur d'adresse pour sélectionner des lignes de bit et un bus d'interconnexion pour relier des lignes de bit sélectionnées à des circuits de lecture, le décodeur d'adresse est agencé pour sélectionner simultanément P lignes de bit de M colonnes différentes de même adresse partielle, et le bus d'interconnexion est agencé pour relier chacune des P lignes de bit sélectionnées à un circuit de lecture.

Selon un mode de réalisation, la mémoire comprend un circuit de balayage d'adresse agencé pour balayer, pendant une opération de lecture d'un mot, les $2^N$ combinaisons possibles des N bits de poids faible d'une adresse appliquée au décodeur d'adresse.

Selon un mode de réalisation, la mémoire comprend des cellules mémoire agencées en lignes de mot et en lignes de bit, une ligne de mot formant une page mémoire, et des moyens d'entrelacement de bits agencés pour : enregistrer M mots de même adresse partielle dans M sous-pages adjacentes d'une page mémoire; enregistrer chaque mot dans P groupes adjacents de cellules comprenant chacun K/P sous-groupes adjacents de cellules, K étant le nombre de bits de chaque mot ; et enregistrer des bits de rang j et +1 d'un mot dans des groupes de cellules adjacents, et des bits de rang j et j+P d'un mot dans des sous-groupes de cellules adjacents, de telle sorte que les mots sont repliés dans les sous-pages.

Selon un mode de réalisation, la mémoire comprend un décodeur d'adresse comprenant des interrupteurs de sélection de ligne de bit, un circuit de programmation de la mémoire comprenant des bascules à verrouillage (LT) connectées en entrée à un bus de données comprenant K fils, le circuit de programmation comprend M fois K bascules à verrouillage (LT), les lignes de bit d'un même sous-groupe de cellules sont reliées à une ligne commune par l'intermédiaire d'interrupteurs de sélection, chaque ligne commune est connectée à la sortie d'une bascule à verrouillage, et les bascules à verrouillage connectées en sortie à des sous-groupes de cellules de même rang appartenant à des sous-pages différentes, sont connectées à un même fil du bus de données.

Selon un mode de réalisation, le décodeur d'adresse comprend des moyens d'inhibition en mode lecture de ses N entrées d'adresse de poids faible, pour sélectionner simultanément toutes les lignes de bit correspondant aux bits de tous les mots de la mémoire ayant la même adresse partielle.

Selon un mode de réalisation, les lignes communes des sous-groupes de cellules d'un même groupe de cellules sont reliées à un même circuit de lecture par l'intermédiaire d'un circuit multiplexeur agencé pour connecter au circuit de lecture une seule ligne commune à la fois, désignée par un signal de commande du circuit multiplexeur.

Selon un mode de réalisation, le moyen de multiplexage est piloté par un circuit de balayage agencé pour balayer au cours d'une opération de lecture d'un mot toutes les valeurs de multiplexage du signal de commande, de telle sorte que les lignes communes de chaque sous-groupe d'un même groupe de cellules sont connectées au circuit de lecture les unes après les autres.

Selon un mode de réalisation, la mémoire comprend un bloc mémoire, des éléments périphériques au bloc mémoire et des moyens d'entrelacement de bits disposés entre l'entrée série et l'entrée du bloc mémoire, agencés pour présenter à l'entrée du bloc mémoire des mots composites comprenant M groupes de P bits de M différents mots binaires.

Selon un mode de réalisation, la mémoire comprend une mémoire tampon de type volatile dont la sortie est reliée à l'entrée du bloc mémoire, et des moyens pour enregistrer dans la mémoire tampon des données devant être enregistrées dans le bloc mémoire, puis enregistrer dans le bloc mémoire les données préalablement enregistrées dans la mémoire tampon.

Selon un mode de réalisation, la mémoire comprend des moyens pour enregistrer dans la mémoire tampon des mots composites comprenant M groupes de P bits de M différents mots binaires reçus sous forme série.

Selon un mode de réalisation, P est égal à K/M, K étant le nombre de bits que comprennent les mots stockés dans la mémoire, M étant égal à $2^N$.

Selon un mode de réalisation, N est égal à 1 et M égal à 2.

Ces objets, caractéristiques et avantages ainsi que d'autres de la présente invention seront exposés plus en détail dans la description suivant du procédé de lecture selon l'invention et de divers modes de réalisation de mémoires permettant de mettre en oeuvre ce procédé, en relation avec les figures jointes parmi lesquelles :

- la figure 1 illustre schématiquement le procédé de lecture selon l'invention,
- la figure 2 représente l'architecture d'un plan mémoire EEPROM,
- la figure 3 représente l'architecture d'un bloc mémoire EEPROM selon l'invention,
- la figure 4 est le schéma électrique d'un élément représenté sous forme de bloc en figure 3,
- la figure 5 représente l'architecture d'une mémoire série selon l'invention réalisée à partir du bloc mémoire de la figure 3,
- la figure 6 est le schéma électrique d'un élément représenté sous forme de bloc en figure 5,
- les figures 7A à 7L représentent divers signaux électriques et illustrent le fonctionnement de la mémoire de la figure 5,
- la figure 8 est omise,
- la figure 9 représente l'architecture d'un bloc mémoire FLASH selon l'invention,
- la figure 10 est omise,
- la figure 11 représente l'architecture d'une mémoire série selon l'invention réalisée à partir du bloc mémoire de la figure 9,
- la figure 12 est omise,
- la figure 13 représente l'architecture d'un bloc mémoire FLASH classique comprenant un entrelacement de bits selon l'invention,
- la figure 14 représente l'architecture d'une mémoire série selon l'invention réalisée à partir du bloc mémoire de la figure 13, et
- la figure 15 représente l'architecture d'une mémoire tampon selon l'invention, représentée sous forme de bloc en figure 14.

**I/ Description du procédé de lecture selon l'invention**

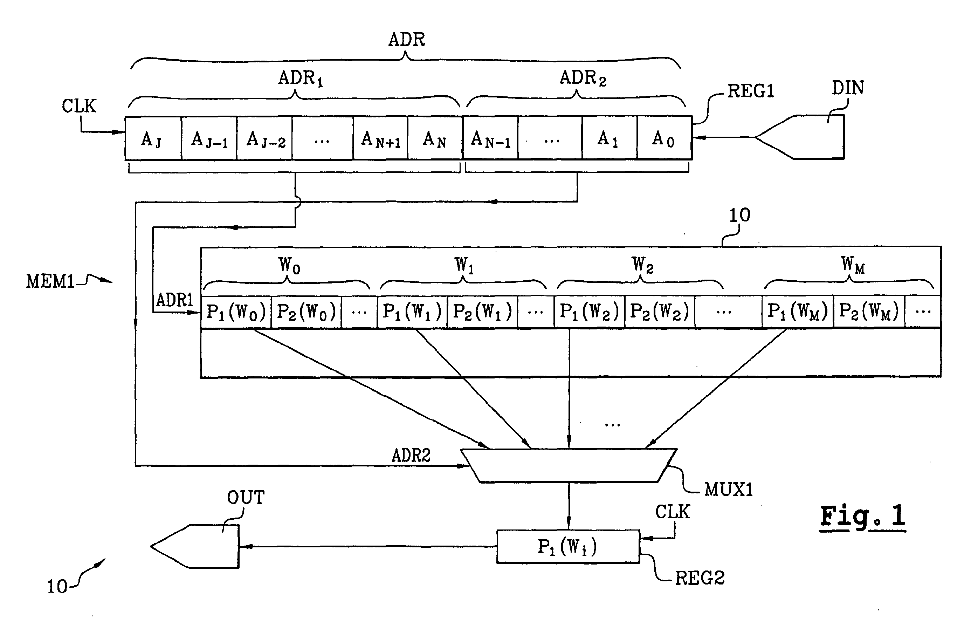

La figure 1 représente très schématiquement une mémoire MEM1 et illustre le procédé de lecture selon l'invention. La mémoire MEM1 comprend une entrée série DIN, un registre à décalage REG1, un bloc mémoire 10, un circuit de sélection MUX1 agencé à la sortie du bloc mémoire 10, un registre à décalage REG2 et une sortie série DOUT. Des adresses sont reçues sur l'entrée DIN et les mots lus dans la mémoire sont émis sur la sortie DOUT. Le registre REG1 comprend une entrée série connectée à l'entrée DIN et une sortie parallèle appliquée au bloc mémoire 10. Le registre REG2 comprend une entrée parallèle connectée à la sortie du bloc mémoire 10 par l'intermédiaire du circuit MUX1, et une sortie série connectée à la sortie DOUT de la mémoire MEM1. Les données sont reçues ou émises bit à bit au rythme d'un signal d'horloge CLK, au moyen des registres REG1 et REG2.

Le procédé de lecture selon l'invention comprend, de façon en soi classique, une étape de lecture de M mots binaires $W_0$, $W_1$... $W_M$ à un instant où l'adresse reçue $ADR_1$ est partielle et ne comprend que des bits de poids fort $A_J$, $A_{J-1}$, $A_{J-2}$...$A_{N+1}$, $A_N$ auxquels il manque N bits de poids faible $A_{N-1}$, $A_{N-2}$, ... $A_0$ pour former une adresse complète ADR.

Selon l'invention, cette étape consiste à lire les P premiers bits des mots $W_0$, $W_1$...$W_M$ ayant la même adresse partielle ADR1, soit des groupes de bits $P_1(W_0)$, $P_1(W_1)$...$P_1(W_M)$, au lieu de lire simultanément tous les bits que comprennent chacun des M mots. Lorsque l'adresse reçue est complète, le groupe de bits $P_1(W_i)$ du mot $W_i$ désigné

par l'adresse complète ADR est sélectionné parmi l'ensemble des groupes de bits lus simultanément, en appliquant au circuit de sélection MUX1 les N bits d'adresse de poids faible $A_{N-1}$, $A_{N-2}$,... $A_0$ reçus pendant le déroulement de la première opération de lecture, formant une adresse de sélection $ADR_2$.

Pendant que les P bits du groupe de bits $P(W_i)$ sont délivrés les uns après les autres sur la sortie DOUT, les P bits suivants du mot désigné par l'adresse complète sont lus dans la mémoire. Cette seconde étape de lecture est de préférence effectuée comme la précédente, en lisant simultanément les P bits suivants des M mots de la mémoire ayant la même adresse partielle, soit les groupes de bits $P_2(W_0)$, $P_2(W_1)$ ...$P_2(W_M)$, puis en sélectionnant un groupe de bits $P_2(W_i)$ au moyen de l'adresse de sélection ADR2. Les bits du groupe $P_2(W_i)$ correspondant au mot $W_i$ désigné par l'adresse complète ADR sont délivrés sur la sortie DOUT lorsque les P premiers bits sont délivrés. Cette étape de lecture est répétée jusqu'à ce que tous les bits du mot désigné par l'adresse complète soient délivrés.

Ainsi, selon l'invention, la lecture d'un mot binaire $W_i$ s'effectue en K/P étapes de lecture simultanée de M groupes de P bits $P_1(W_i)$, $P_2(W_i)$, $P_3(W_i)$, ... $P_{K/P}(W_i)$, K désignant le nombre de bits que comprennent chacun des mots de la mémoire, K/P étant nécessairement un nombre entier. Le nombre de bits lus simultanément dans la mémoire à chaque étape de lecture est égal au produit de P par M (M étant égal à $2^N$). De préférence, P est égal à K/M, soit $K/2^N$, de sorte que le nombre total de bits lus simultanément dans la mémoire à chaque étape de lecture est égal à K. En d'autres termes, le procédé selon l'invention ne nécessite que K circuits de lecture, soit le même nombre de circuits de lecture qu'une mémoire conventionnelle comprenant des mots de K bits et fonctionnant sans anticipation.

En admettant que les bits d'adresse soient reçus à raison d'un bit par cycle d'horloge, ce qui est le cas en pratique, le temps Tr conféré pour lire le premier groupe de bits $P_1(W_i)$ et délivrer les premiers bits sur la sortie DOUT est égal à :

$$Tr = NT + kT,$$

T étant la période d'horloge et kT le temps conféré entre la réception du dernier bit d'adresse $A_0$ et l'émission du premier bit de donnée. Rappelons que le paramètre k est classiquement égal à 0,5 avec un bus SPI (le pire cas) et est égal à 1,5 avec un bus Microwire ou I2C. Le nombre N représente ainsi le nombre de cycles d'horloge gagné pour la première étape de lecture, relativement à une lecture sans anticipation.

Par ailleurs, le temps Ts conféré pour lire les groupes de bits suivants $P_2(W_i)$, $P_3(W_i)$, ... $P_{K/P}(W_i)$ est au maximum égal à :

$$Ts = PT$$

et ne dépend que du nombre P de bits de chaque groupe.

Les nombres N et P étant des paramètres du procédé de l'invention, le temps Tr de lecture du premier groupe de bits augmente en fonction de N jusqu'à ce que le temps Ts devienne inférieur au temps Tr. A partir de cette valeur, ce n'est donc plus le temps Tr dont on dispose pour lire le premier groupe de bits qui constitue une limitation, mais le temps Ts dont on dispose pour lire les groupes de bits suivants.

Le procédé selon l'invention peut être résumé ainsi, pour une valeur de N donnée :

- $M = 2^N$
- K/P est un nombre entier,
- P est de préférence égal à K/M, soit $K/2^N$, afin de conserver un nombre K constant de circuits de lecture comparativement à une mémoire conventionnelle comprenant des mots de K bits,
- le temps Tr conféré pour la lecture du premier groupe de bits est égal à NT + kT,
- le temps Ts conféré pour la lecture des groupes de bits suivants est égal à PT, soit (K/M)T,
- l'optimum en temps de lecture Tr est atteint quand Ts devient inférieur à Tr, soit :

$$(K/M)T \leq NT + kT$$

On en déduit que :

$$K/M \leq N + k$$

soit :

$$K/2^N \leq N + k$$

ou :

$$K \leq 2^N (N + k)$$

Par exemple, lorsque K = 8 bits et k = 0,5 le nombre N optimum est égal à 2, M est égal à 4, P est égal à 2, et le procédé de l'invention comprend 4 cycles de lecture de 4 groupes de 2 bits choisis dans 4 mots binaires ayant la même adresse partielle. Le temps Ts conféré pour la lecture du premier groupe est de 2,5 cycles d'horloge (au lieu de 0,5 cycle d'horloge sans anticipation) et le temps conféré pour la lecture des trois groupes de bits suivants est de 2 cycles d'horloge. Toutefois, en pratique, il peut n'être pas nécessaire de rechercher le temps de lecture optimal. Le choix de N=1 conférera dans la plupart des cas un gain de temps suffisant (1 cycle d'horloge) pour résoudre le problème exposé au préambule.

Dans ce qui suit, on décrira divers modes de réalisation de mémoires programmables et effaçables électriquement permettant de mettre en oeuvre ce procédé, sans perdre de vue que l'objectif initial de la présente invention est de simplifier l'architecture des mémoires à lecture par anticipation en diminuant le nombre de circuits de lecture. En d'autres termes, les architectures de mémoires selon l'invention ne doivent pas être trop complexes, ce qui ferait perdre l'avantage lié à la diminution du nombre de circuits de lecture.

Dans un souci de simplicité, la description ci-après de divers modes de réalisation de mémoires selon l'invention sera faite en choisissant N égal à 1 et M égal à 2. Une adresse complète comprendra 16 bits $A_{15}$ à $A_0$, le bit $A_0$ représentant l'adresse de sélection et les bits $A_{15}$-$A_1$ représentant l'adresse partielle. De préférence, les P premiers bits de chacun des mots lus simultanément dans la mémoire seront les bits de poids fort, qui sont généralement envoyés les premiers sur un bus série.

**II/ Mise en oeuvre du procédé dans une mémoire EEPROM**

**A/ Architecture d'un plan mémoire EEPROM**

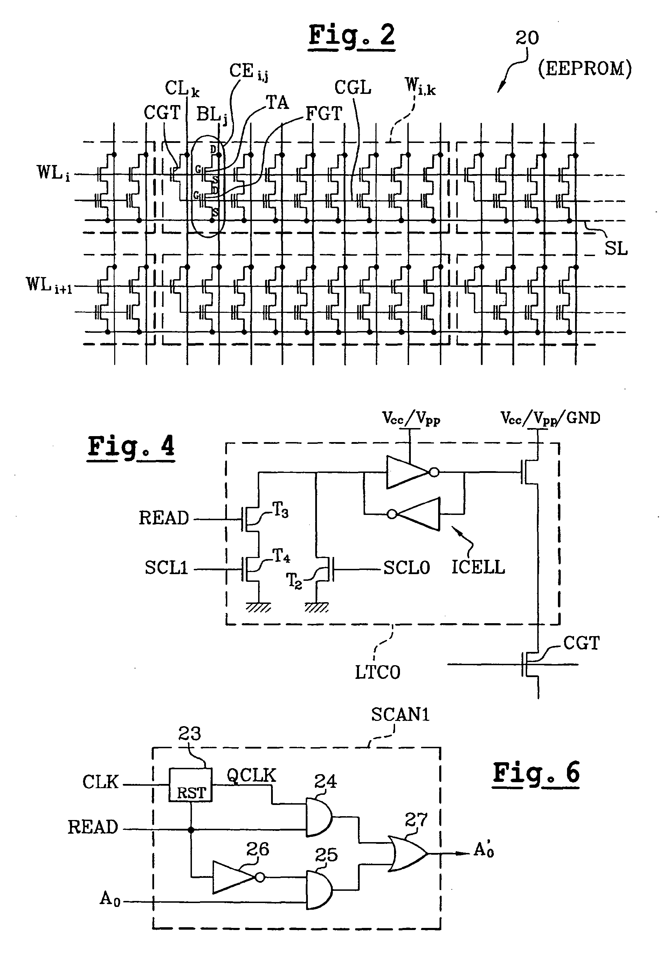

A titre de rappel, la figure 2 représente schématiquement et partiellement le coeur d'une mémoire EEPROM, ou "plan mémoire" EEPROM 20. Le plan mémoire 20 comprend une pluralité de cellules mémoire $CE_{i,j}$ agencées de façon matricielle et connectées à des lignes de mot $WL_i$ et des lignes de bit $BL_j$. Chaque cellule $CE_{i,j}$ comprend un transistor à grille flottante FGT et un transistor d'accès TA. Le transistor d'accès TA a sa grille G connectée à une ligne de mot $WL_i$, son drain D connecté à une ligne de bit $BL_j$, sa source S étant connectée au drain D du transistor FGT. Le transistor FGT a sa grille G reliée à une ligne de sélection de colonne $CL_k$ par l'intermédiaire d'une ligne de contrôle de grille CGL et d'un transistor de contrôle de grille CGT, et sa source S connectée à une ligne de source SL, la grille du transistor CGT étant connectée à la ligne de mot $WL_i$. Ainsi, les cellules mémoire $CE_{i,j}$ d'une même ligne de mot $WL_i$ sont arrangées en colonnes de rang k, et forment des mots $W_{i,k}$, généralement des octets, pouvant être sélectionnés en lecture au moyen de la ligne de sélection de colonne $CL_k$ et de la ligne de mot $WL_i$ auxquelles ils sont rattachés.

Dans un tel plan mémoire EEPROM, une opération d'effacement ou de programmation d'une cellule consiste dans l'injection ou l'extraction de charges électriques par effet tunnel (effet Fowler Nordheim) dans la grille flottante du transistor FGT de la cellule. Un transistor FGT effacé présente une tension de seuil positive VT1 et un transistor FGT programmé présente une tension de seuil négative VT2. Lorsqu'une tension de lecture Vread comprise entre VT1 et VT2 est appliquée sur sa grille, un transistor effacé reste bloqué, ce qui correspond par convention à un "1" logique, et un transistor programmé est passant, ce qui correspond par convention à un "0" logique. L'opération d'effacement est réalisée en appliquant une tension d'effacement Vpp de l'ordre de 12 à 20 V sur la grille G du transistor FGT pendant que la ligne de source SL est portée à la masse. L'opération de programmation est réalisée en appliquant une tension de programmation Vpp sur le drain D du transistor FGT, par l'intermédiaire du transistor d'accès TA, pendant que la grille est portée à la masse. Les transferts de charges par effet tunnel s'effectuant avec un courant de grille quasiment nul, un grand nombre de cellules mémoire EEPROM peuvent être effacées ou programmées simultanément.

**B/ Architecture d'un bloc mémoire EEPROM selon l'invention**

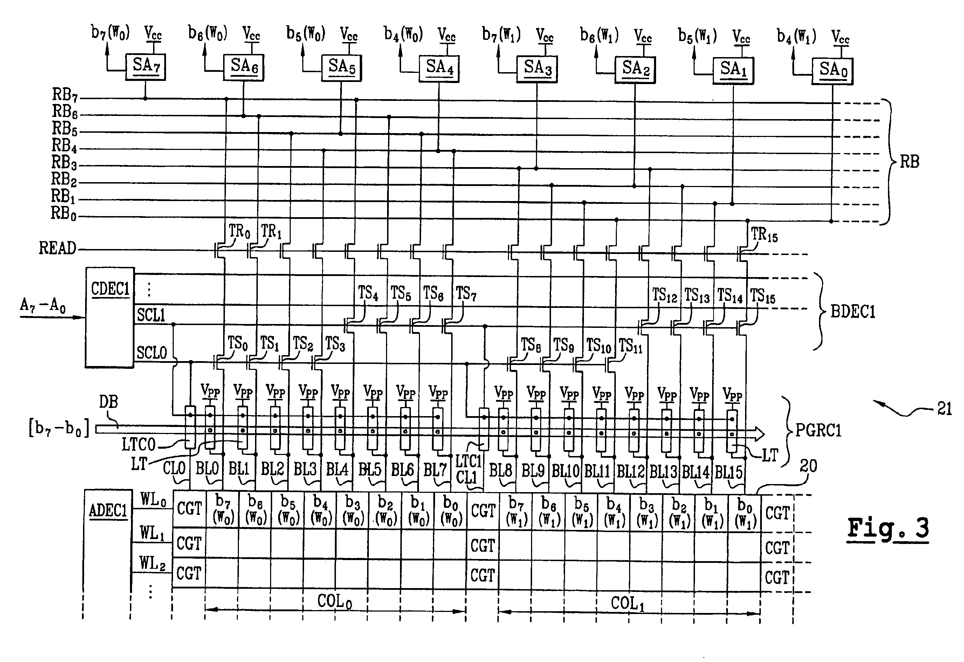

La figure 3 représente un bloc mémoire 21 selon l'invention comprenant un plan mémoire EEPROM 20 semblable à celui qui vient d'être décrit. Pour des raisons de lisibilité de la figure, on n'a représenté de façon détaillée que deux colonnes $COL_0$, $COL_1$ du plan mémoire 20 et quatre lignes de mot $WL_0$ à $WL_4$. Les colonnes $COL_0$, $COL_1$ comprennent huit lignes de bit chacune, respectivement $BL_0$ à $BL_7$, $BL_8$ à $BL_{13}$. Dans ce qui suit, on se limitera à la description de l'architecture du bloc mémoire 21 en relation avec les colonnes $COL_0$ et $COL_1$, étant entendu que cette architecture se répète pour les autres colonnes du plan mémoire. Sont représentés les bits $b_0$ à $b_7$ de deux mots binaires $W_0$, $W_1$ de coordonnées respectives $WL_0/COL_0$ et $WL_0/COL_1$ et d'adresses $0000_H$ et $0001_H$ (notation hexadécimale). Ces bits sont désignés respectivement $b_0(W_0)$ à $b_7(W_0)$ et $b_0(W_1)$ à $b_7(W_1)$.

Le bloc mémoire 21 comprend de façon classique, outre le plan mémoire 20, un décodeur de ligne ADEC1, un décodeur de colonne BDEC1, des circuits de lecture $SA_0$ à $SA_7$ et un circuit de programmation PGRC1. Le décodeur ADEC1 reçoit en entrée des bits d'adresse de poids fort, ici huit bits $A_8$ à $A_{15}$ (soit 256 lignes de mot), et sélectionne sur sa sortie l'une des lignes de mot $WL_i$ désignée par l'adresse reçue, l'ensemble des mots d'une ligne de mot formant une page du plan mémoire 20. Le décodeur BDEC1 reçoit des bits d'adresse de poids faible, ici huit bits $A_0$ à $A_7$ (soit 256 colonnes) définissant l'adresse d'une colonne, c'est-à-dire l'adresse d'un mot dans une page.

On distingue dans le bloc mémoire 21 un chemin de lecture et un chemin d'écriture. Selon l'invention, le chemin de lecture permet de délivrer, sur application d'une adresse complète, des groupes de P bits de M mots binaires ayant la même adresse partielle, ici quatre bits de deux mots. Le chemin d'écriture, dont la structure sera rappelée plus loin, est en soi de type classique.

Chemin de lecture :

Le décodeur de colonne BDEC1 comprend un bloc de décodage CDEC1 et des transistors de sélection $TS_0$ à $TS_{15}$ pilotés par le bloc de décodage CDEC1. Chaque ligne de bit $BL_0$ à $BL_{15}$ est reliée à un circuit de lecture $SA_0$ à $SA_7$ par l'intermédiaire d'un transistor de sélection $TS_0$ à $TS_{15}$, d'un transistor de lecture $TR_0$ à $TR_{15}$ et d'un bus d'interconnexion RB. Le bus RB comprend huit fils $RB_0$ à $RB_7$, chaque fil étant connecté à un circuit de lecture $SA_0$ à $SA_7$. Les transistors de lecture $TR_0$ à $TR_{15}$, agencés en série avec les transistors $TS_0$ à $TS_{15}$, sont pilotés par un signal READ (commande de grille), mis à 1 en mode lecture.

Selon l'invention, les transistors de sélection $TS_4$ à $TS_7$ des lignes de bit $BL_4$ à $BL_7$ de la colonne $COL_0$ et les transistors de sélection $TS_{12}$ à $TS_{15}$ des lignes de bit $BL_{12}$ à $BL_{15}$ de la colonne $COL_1$ sont pilotés par la sortie $SCL_1$ (sélection colonne 1) du bloc de décodage CDEC1. Les transistors de sélection $TS_0$ à $TS_3$ des lignes de bit $BL_0$ à $BL_3$ de la colonne $COL_0$ et les transistors de sélection $TS_8$ à $TS_{11}$ des lignes de bit $BL_8$ à $BL_{11}$ de la colonne $COL_1$ sont pilotés par la sortie $SCL_0$ (sélection colonne 0) du bloc de décodage CDEC1. Toujours selon l'invention, les lignes de bit de rang j et j+4 (soit j+P) de chaque colonne sont reliées à un même circuit de lecture $SA_j$ par l'intermédiaire du bus d'interconnexion RB, tandis que les lignes de bit de même rang de deux mots ayant la même adresse partielle (bits $A_{15}$-$A_1$ identiques) sont reliées à des circuits de lecture différents. En résumé, les lignes de bit sont reliées ici aux circuits de lecture de la façon décrite dans le tableau 1 ci-après, par l'intermédiaire d'un transistor de sélection et d'un transistor de lecture.

Tableau 1

| Lignes de bit : | Reliées à (*): |
| --- | --- |
| $BL_0$, $BL_4$ (mot $W_0$) | $SA_0$ |
| $BL_1$, $BL_5$ (mot $W_0$) | $SA_1$ |
| $BL_2$, $BL_6$ (mot $W_0$) | $SA_2$ |
| $BL_3$, $BL_7$ (mot $W_0$) | $SA_3$ |
| $BL_4$, $BL_8$ (mot $W_1$) | $SA_4$ |
| $BL_5$, $BL_9$ (mot $W_1$) | $SA_5$ |
| $BL_6$, $BL_{10}$ (mot $W_1$) | $SA_6$ |
| $BL_7$, $BL_{11}$ (mot $W_1$) | $SA_7$ |

Ainsi, en mode lecture (READ=1), l'application d'une adresse paire ($A_0$=0) au décodeur BDEC1 déclenche la lecture des quatre bits de poids fort de deux mots ayant la même adresse partielle, et l'application d'une adresse impaire

($A_0$=1) déclenche la lecture des quatre bits de poids faible de deux mots ayant la même adresse partielle. "Par exemple, l'application de l'adresse $0000_H$ aux décodeurs ADEC1, BDEC1 déclenche la lecture des bits $b_7$ à $b_4$ de chaque mot $W_0$, $W_1$, qui se retrouvent sur les sorties des circuits $SA_7$ à $SA_0$, et l'application de l'adresse $0001_H$ aux décodeurs déclenche la lecture des bits $b_3$ à $b_0$ de chaque mot $W_0$, $W_1$.

De façon générale, un bloc mémoire EEPROM selon l'invention se distingue ainsi de l'art antérieur par le fait que l'application d'une adresse complète ou partielle suivie du signal de lecture READ déclenche la lecture des groupes de P bits de M mots ayant la même adresse partielle.

Chemin d'écriture :

Le circuit de programmation PGRC1 comprend de façon classique une pluralité de bascules à verrouillage LT ("latch") alimentées par la haute tension Vpp pendant les périodes de programmation de cellules. Le nombre de bascules LT est ici égal au nombre de lignes de bit du plan mémoire afin de permettre la programmation simultanée de tous les mots d'une ligne de mot (programmation en mode page). Chaque bascule LT a sa sortie connectée à une ligne de bit BL et son entrée connectée à un fil du bus de données DB. Les bascules LT connectées aux lignes de bit $BL_0$ à $BL_7$ de la colonne $COL_0$ sont activées par la sortie $SCL_0$ du bloc de décodage CDEC1, les bascules LT connectées aux lignes de bit $BL_8$ à $BL_{15}$ de la colonne $COL_1$ sont activées par la sortie $SCL_1$ du bloc de décodage CDEC1, etc.. Chaque bascule LT délivre la tension de programmation Vpp lorsqu'elle est activée par le bloc de décodage CDEC1, si le bit présenté sur son entrée est à 1.

Eléments communs pour l'écriture et la lecture :

Le circuit de programmation PGRC1 comprend également des bascules à verrouillage LTC assurant la polarisation des lignes de colonne $COL_j$ connectées aux drains des transistors de contrôle de grille CGT. Ces bascules LTC sont utilisées ici en mode lecture pour délivrer la tension Vcc, et sont utilisées en mode programmation ou effacement pour délivrer une tension nulle (programmation) ou la tension Vpp (effacement). Selon l'invention, chaque bascule LTC est activée en mode lecture par l'une quelconque des sorties du bloc de décodage CDEC1 ayant la même adresse partielle que la colonne à laquelle la bascule est rattachée. Par exemple, les bascules $LTC_0$, $LTC_1$ des colonnes $COL_0$, $COL_1$ sont activées en lecture par l'une quelconque des deux sorties $SCL_0$, $SCL_1$ du bloc de décodage CDEC1. Par contre, en mode programmation ou effacement, chaque bascule LTC est exclusivement activée par la sortie $SCL_0$, $SCL_1$ correspondant à la colonne à laquelle elle est rattachée.

Un exemple de réalisation de la bascule $LTC_0$ est représenté schématiquement en figure 4. La bascule $LTC_0$ comprend une cellule inverseuse à mémoire ICELL constituée par deux portes inverseuses tête-bêche, dont la sortie pilote la grille d'un transistor T1. Le transistor T1 a sa source connectée au transistor CGT et reçoit sur son drain la tension Vpp pendant les opérations d'effacement de cellules, une tension nulle (masse) pendant les opérations de programmation, ou la tension Vcc pendant les opérations de lecture. L'entrée de la cellule ICELL est reliée à la masse par deux branches inverseuses, la première branche comprenant un transistor T2 piloté par le signal de sélection $SCL_0$ et la deuxième comprenant en série deux transistors T3, T4 pilotés respectivement par le signal READ et le signal de sélection $SCL_1$.

En mode programmation ou effacement, le signal READ est égal à 0 et seul le signal $SCL_0$ peut mettre à 0 l'entrée de la porte ICELL pour activer la sortie de la bascule LTC0. Le transistor T1 devient alors passant et connecte à la masse (programmation de cellules) ou à la tension Vpp (effacement de cellules) le transistor CGT. En mode lecture (READ=1), le passage à 1 de l'un quelconque des signaux de sélection $SCL_0$, $SCL_1$ permet de mettre à 0 l'entrée de la cellule ICELL. Le transistor T1 devient passant et connecte le transistor CGT correspondant à la tension Vcc.

**C/ Architecture d'une mémoire EEPROM selon l'invention**

On a décrit dans ce qui précède un bloc mémoire EEPROM 21 prévu pour délivrer quatre bits de poids fort de deux mots de même adresse partielle sur application d'une adresse paire ($A_0$=0) et quatre bits de poids faible de ces deux mots sur application d'une adresse impaire correspondante ($A_0$=1). Comme on l'a déjà indiqué, ce mode de lecture est un cas particulier de lecture simultanée de groupes de P bits dans M mots ayant la même adresse partielle, quand N = 1, M = 2 et P = 4. On va maintenant montrer comment les propriétés du bloc mémoire peuvent être exploitées de façon dynamique pour mettre en oeuvre le procédé de l'invention.

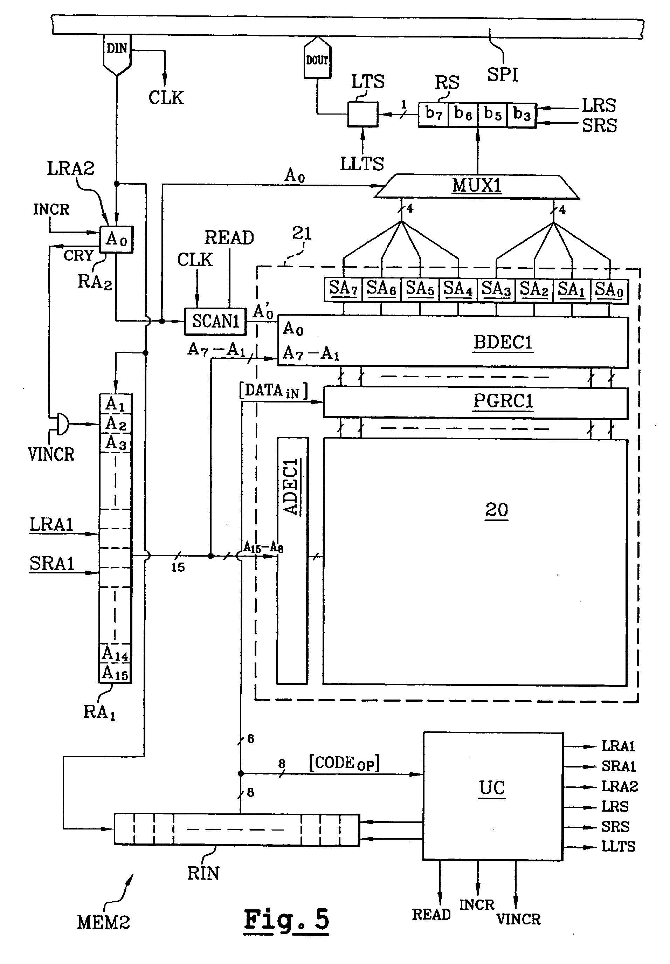

La figure 5 représente schématiquement une mémoire MEM2 série selon l'invention, comprenant un port d'entrée série DIN et un port de sortie série DOUT connectés ici à un bus SPI. La mémoire MEM2 est réalisée à partir du bloc mémoire EEPROM 21 auquel sont ajoutés divers éléments périphériques assurant la gestion des flux de données en entrée-sortie ainsi que la mise en oeuvre du procédé de l'invention. On distingue parmi ces divers éléments périphériques des registres à décalage RA1, RA1, RIN à entrée série et sortie parallèle, un circuit de balayage d'adresse SCAN1, un circuit de sélection MUX1, un registre à décalage RS à entrée parallèle et sortie série, et un registre à verrouillage LTS. L'ensemble est piloté par une unité centrale UC à logique câblée ou à microprocesseur.

Le registre RA1, ici de 15 bits, a son entrée série connectée au port DIN et sa sortie parallèle délivre les bits d'adresse $A_{15}$ à $A_1$. Les bits $A_{15}$ à $A_8$ sont envoyés sur les entrées correspondantes du décodeur de ligne de mot ADEC1 et les bits $A_7$ à $A_1$ sont envoyés sur les entrées correspondantes du décodeur de colonne BDEC1. Le registre RA2, ici de 1 bit, a son entrée série connectée au port DIN et sa sortie délivre le bit d'adresse $A_0$. Le bit $A_0$ est appliqué sur l'entrée de commande du circuit MUX1. Le bit $A_0$ est également appliqué à l'entrée du circuit SCAN1 dont la sortie est connectée à l'entrée d'adresse $A_0$ du décodeur de colonne BDEC1. Le registre RIN, de 8 bits, a son entrée série connectée au port DIN et sa sortie parallèle connectée à l'entrée de l'unité centrale UC et à l'entrée du circuit de programmation PGRC1 (bloc mémoire 21). Le circuit de sélection MUX1 est connecté en entrée aux sorties des circuits de lecture $SA_0$ à $SA_7$ (bloc mémoire 21) et est connecté en sortie à l'entrée parallèle du registre à décalage RS. La sortie série du registre RS est appliquée à l'entrée du registre LTS, dont la sortie est connectée au port DOUT.

Le circuit SCAN1, représenté plus en détail en figure 6, comprend un diviseur de fréquence 23 recevant en entrée le signal d'horloge CLK du bus SPI, ainsi que deux portes "ET" 24, 25, une porte inverseuse 26 et une porte "OU" 27. Le diviseur 23, ici un diviseur par 4 (car P = 4), reçoit le signal READ sur son entrée de remise à zéro RST et délivre un signal QCLK dont la fréquence est quatre fois plus lente que le signal d'horloge CLK. Le signal QCKL est appliqué sur une entrée de la porte 24 dont l'autre entrée reçoit le signal READ. La porte 25 reçoit sur ses entrées le bit d'adresse de poids faible $A_0$ et le signal inversé /READ délivré par la porte 26. La porte 27 reçoit en entrée les sorties des portes 24, 25 et délivre un bit $A_0$'.

A la sortie du circuit SCAN1, le bit $A_0$' recopie le bit de poids faible $A_0$ quand le signal READ est à 0 (porte 24 inhibée, circuit SCAN1 transparent) ou recopie le signal QCLK quand le signal READ est à 1 (porte 25 inhibée, circuit SCAN1 actif). Le signal QCLK est à 0 pendant les quatre premiers cycles d'horloge après le passage à 1 du signal READ, puis passe à 1 les quatre cycles d'horloge suivants, etc..

On se référera de nouveau à la figure 5. Le fonctionnement général de la mémoire MEM2 en ce qui concerne la gestion des flux de données en entrée et la réalisation d'opérations d'écriture, est en soi classique et ne sera pas décrit en détail. Les codes opération [$CODE_{OP}$] des instructions à exécuter sont reçus bit à bit dans le registre RIN par des opérations successives de chargement et de décalage du registre, puis sont envoyés à l'unité centrale UC pour décodage. Les données reçues [$DATA_{IN}$] à enregistrer dans le bloc mémoire sont également reçues par le registre RIN et appliquées ensuite à l'entrée du circuit de programmation PGRC1. Les adresses d'enregistrement ou de lecture de mots sont reçues dans les registres RA1 et RA2.

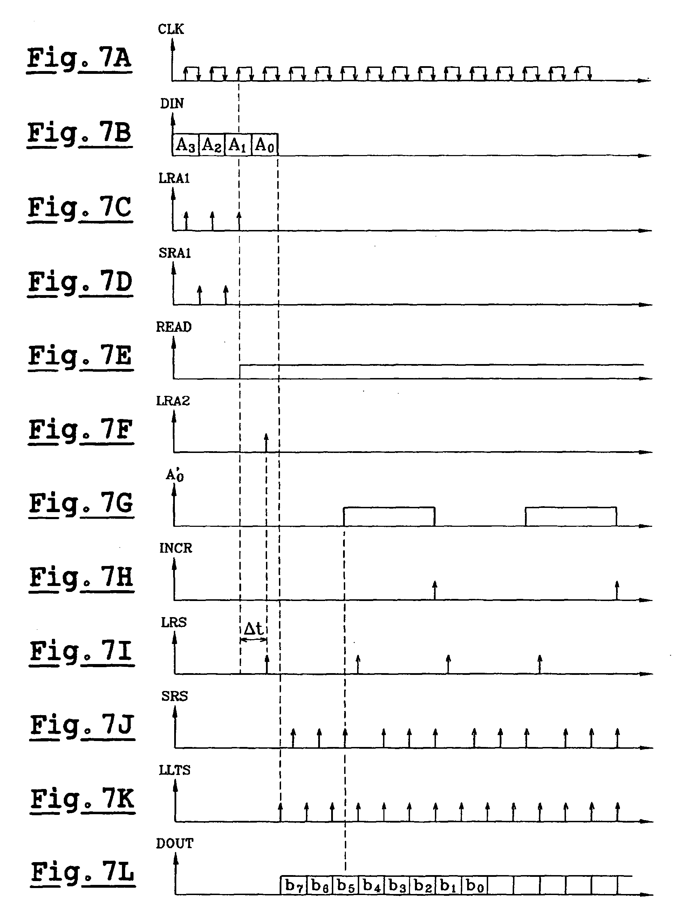

Le fonctionnement de la mémoire MEM2 en mode lecture est illustré par les figures 7A à 7L, qui représentent respectivement les signaux suivants, délivrés par l'unité centrale UC :

- CLK : signal d'horloge de synchronisation,
- DIN : données (bits d'adresse) reçues sur le port DIN,
- LRA1 : chargement d'un bit dans le registre RA1
- SRA1 : décalage d'un bit du registre RA1
- READ : signal de lecture
- LRA2 : chargement d'un bit dans le registre RA2
- $A_0$' : signal délivré par le circuit SCAN1,
- INCR : incrémentation du registre RA2
- LRS : chargement en parallèle du registre RS
- SRS : décalage d'un bit du registre RS
- LLTS : chargement d'un bit dans le registre LTS
- DOUT : données (bits d'un mot) émises sur le port DIN,

Ces figures illustrent le processus de lecture après réception du code opération [$CODE_{READ}$] de l'instruction de lecture et réception des premiers bits d'adresse $A_{15}$ à $A_4$. La réception de ces bits d'adresse, illustrée par les figures 7A à 7D, est assurée par des étapes de chargement (LRA1) du registre RA1 en milieu de cycle d'horloge et de décalage (SRA1) du registre RA1 en fin de période d'horloge. L'avant dernier bit d'adresse $A_1$ est enregistré dans le registre RA1 et le dernier bit $A_0$ est enregistré dans le registre RA2 (signal LRA2, fig. 7F).

Le signal READ (fig. 7E) est émis sensiblement à l'instant où le bit $A_1$ est chargé dans le registre RA1. A cet instant, le registre RA1 est plein et contient l'adresse partielle $A_{15}$-$A_1$. Le passage à 1 du signal READ active le circuit SCAN1 qui délivre un bit $A_0$' égal à 0 pour une durée de quatre cycles d'horloge CLK (fig. 7G). Le bloc mémoire 21 reçoit ainsi une adresse paire, l'entrée $A_0$ du bloc de décodage étant forcée à 0. Le bloc mémoire délivre les quatre bits de poids fort $b_7$ à $b_4$ de chaque mot $W_0$, $W_1$ de même adresse partielle, qui se retrouvent sur les sorties des circuits $SA_7$ à $SA_0$ (fig. 5). Lorsque le bit $A_0$ est reçu et enregistré dans le registre RA2 (fig. 7F), le bit $A_0$ se retrouve sur l'entrée de commande du circuit MUX1 pour sélection du groupe de bits $b_7$-$b_4$ du mot désigné par l'adresse complète. Sensiblement au même instant, le signal de chargement LRS est appliqué au registre RS (fig. 7J). Ce dernier est donc chargé par le groupe de bits $b_7$-$b_4$ sélectionné et le bit $b_7$ est délivré sur sa sortie. Au front descendant du cycle d'horloge, c'est-à-dire 0,5 cycle d'horloge après la réception du dernier bit d'adresse $A_0$, le signal LLTS de chargement du registre de sortie LTS est émis (fig. 7K) et le bit $b_7$ est émis sur le port DOUT.

Le temps $\Delta t$ gagné ici pour la lecture du premier groupe de bits $b_7$-$b_4$ est de 1 cycle d'horloge (N=1), et s'ajoute au demi cycle d'horloge séparant la réception du dernier bit d'adresse de l'émission du premier bit de donnée. Ce résultat est atteint avec seulement huit circuits de lecture SA$_0$-SA$_7$ contre seize dans une mémoire à anticipation classique, et avec un registre de sortie RS ne comprenant que quatre bits.

Après l'émission du premier bit $b_7$, les bits suivants $b_6$ à $b_4$ sont émis par des décalages successifs du registre RS et chargements du registre LTS (fig. 7J, 7K). Au cinquième cycle d'horloge suivant le déclenchement de l'étape de lecture par anticipation, soit pendant l'émission du bit $b_5$, le bit $A_0$' en sortie du circuit de balayage SCAN passe automatiquement à 1 (fig. 7G) et le processus de lecture est de nouveau engagé pour la lecture des bits suivants, ici les bits de poids faible $b_3$ à $b_0$ de chacun des mots $W_0$, $W_1$. Lorsque le bit $b_4$ est émis, le signal LRS de chargement du registre RS est de nouveau émis sur front descendant du signal d'horloge et les bits $b_3$ à $b_0$ sont émis sur le port DOUT de la même manière que les précédents.

De façon optionnelle, la mémoire MEM1 peut fonctionner en mode de lecture séquentielle et continuer à lire, après la lecture du mot désigné par l'adresse reçu, une pluralité de mots dont le nombre est indiqué dans l'instruction de lecture. Dans ce cas, comme illustré en figures 5 et 7H, un signal d'incrémentation INCR est appliqué au registre RA2 pendant l'émission des bits de poids faible du mot précédent. Le signal de débordement CRY du registre RA2 est appliqué au registre RA1 en tant que signal d'incrémentation, par l'intermédiaire d'une porte "ET" recevant sur son autre entrée un signal de validation VINCR délivré par l'unité centrale UC. Le signal VINCR doit être à 1 pour que le mode de lecture séquentielle soit validé.

**III/ Mise en oeuvre du procédé dans une mémoire FLASH III-I/ Introduction**

**A/ Architecture d'un plan mémoire FLASH**

A titre de rappel, la figure 8 représente schématiquement le coeur d'une mémoire FLASH, ou plan mémoire FLASH 30. Le plan mémoire 30 comprend une pluralité de cellules mémoire, respectivement CE$_{i,j}$, CF$_{i,j}$, agencées de façon matricielle et connectées à des lignes de mot WL$_i$ et des lignes de bit BL$_j$. Les cellules CF$_{i,j}$ du plan mémoire FLASH sont d'une structure plus simple que des cellules de mémoire EEPROM et ne comportent qu'un transistor à grille flottante FGT. Le transistor FGT a sa grille G connectée à une ligne de mot WL$_i$, son drain D connecté à une ligne de bit BL$_j$ et sa source S connectée à une ligne de source SL. L'arrangement des cellules d'un même mot peut être progressif ou entrelacé, de sorte qu'un mot $W_{i,k}$ rattaché à ligne de rang i et à une colonne de rang k peut comprendre huit cellules agencées côte à côte comme représenté sur la figure 8 ou comprendre, dans le cas d'un entrelacement, des cellules non adjacentes. Dans l'art antérieur, les cellules physiquement adjacentes sont généralement les cellules de même rang des mots d'une même ligne de mot.

Dans un tel plan mémoire FLASH, une opération d'effacement d'une cellule consiste dans l'extraction par effet tunnel de charges électriques piégées dans la grille flottante, tandis qu'une opération de programmation consiste dans l'injection de charges dans la grille flottante par effet dit "d'injection d'électrons chauds" (Hot electron injection). Un transistor FGT effacé présente une tension de seuil positive VT1 de faible valeur, et un transistor programmé présente une tension de seuil VT2 supérieure à VT1. Lorsqu'une tension de lecture Vread comprise entre VT1 et VT2 est appliquée sur sa grille, un transistor effacé est passant, ce qui correspond par convention à un "1" logique, et un transistor programmé reste bloqué, ce qui correspond par convention à un "0" logique.

En raison de leur simplicité, les mémoires FLASH présentent l'avantage d'une grande compacité en termes de surface de silicium occupée et présentent ainsi, à surface de silicium constante, une capacité de stockage nettement supérieure à celle des mémoires EEPROM, pour un prix de revient inférieur.

En revanche, les mémoires FLASH offrent des possibilités de programmation plus réduites que les mémoires EEPROM, notamment en ce qui concerne la possibilité d'enregistrer simultanément plusieurs mots. En effet, l'opération de programmation d'une cellule FLASH, par injection d'électrons chauds, s'effectue avec un courant non négligeable en appliquant au transistor FGT de la cellule une tension Vppd de drain de l'ordre de 6 V et une tension de grille Vppg de l'ordre de 12 V, le transistor FGT étant dans l'état passant et fortement polarisé pendant l'opération.

Ainsi, la programmation simultanée d'un grand nombre de cellules FLASH s'avère impossible en raison du courant important collecté dans les lignes de source SL, qui est capable de détruire les pistes métalliques reliant les transistors de la mémoire et/ou les connexions entre pistes de niveaux différents. En pratique, le nombre de cellules pouvant être simultanément programmées est généralement limité à huit, de sorte qu'une mémoire FLASH ne peut permettre l'enregistrement simultané de plusieurs mots et fonctionne toujours selon le mode de programmation "mot par mot".

**B/ Solutions pour mettre en oeuvre le procédé de l'invention**

Les idées et principes mis en oeuvre dans le bloc mémoire EEPROM décrit plus haut sont transposables à une architecture de mémoire FLASH, pour obtenir une lecture simultanée de groupes de P bits de M mots binaires. Toutefois, une telle transposition conduit à réaliser une mémoire FLASH complexe (pourvue notamment d'un bus de lecture) et fait perdre les avantages offerts par ce type de mémoire en termes de compacité.

Ici, l'idée de la présente invention est de tirer parti de la possibilité d'entrelacement de bits offerte par les mémoires FLASH, et de prévoir un entrelacement permettant de lire simultanément des groupes de P bits de M mots binaires sans compliquer de façon rédhibitoire l'architecture de la mémoire. Un tel entrelacement de bits doit être réalisé au stade de l'enregistrement des mots binaires dans la mémoire FLASH, alors qu'il s'effectuait au moment de la lecture des mots binaires dans la mémoire EEPROM décrite plus haut.

La présente invention prévoit ici deux solutions présentant chacune des avantages selon l'application visée. La première solution consiste à modifier le chemin d'écriture à l'intérieur d'un bloc mémoire FLASH pour obtenir l'entrelacement désiré au moment de l'enregistrement des mots binaires. Un mode de réalisation conforme à cette solution sera décrit ci-après en section III-2. La deuxième solution est de prévoir des moyens externes agencés sur le chemin de données conduisant à l'entrée de la mémoire, assurant l'entrelacement des mots binaires avant leur introduction dans la mémoire. Un mode de réalisation conforme à cette solution sera décrit plus loin en section III-3.

**III-2/ Premier mode de réalisation**

**A/ Architecture d'un bloc mémoire FLASH selon l'invention**

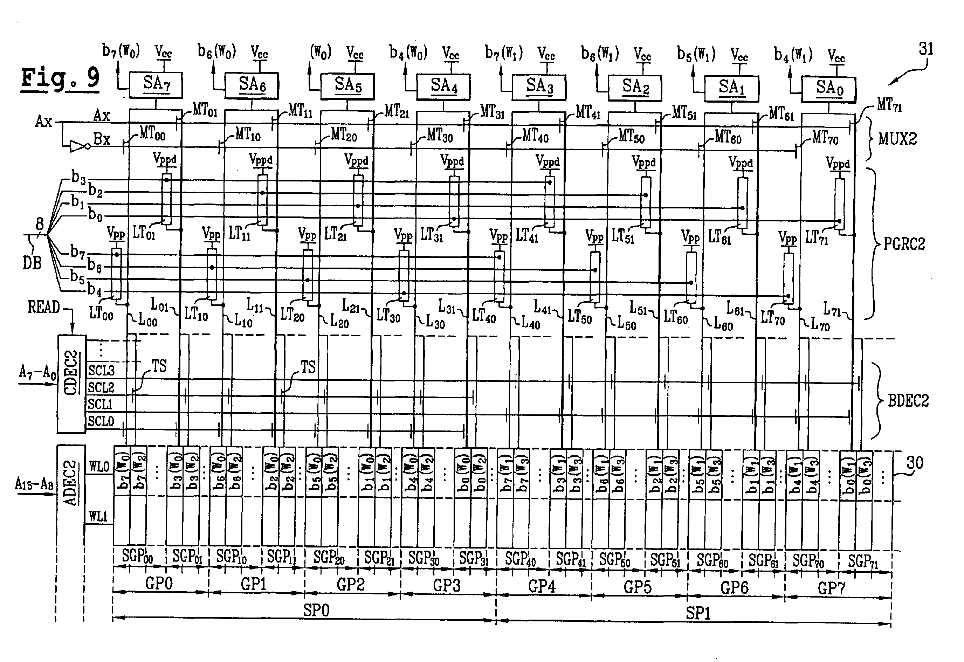

La figure 9 représente l'architecture d'un bloc mémoire FLASH 31 selon l'invention, comprenant un plan mémoire 30 du type précédemment décrit, un décodeur de ligne de mot ADEC2, un décodeur de ligne de bit BDEC2 comprenant un bloc de décodage CDEC2 et des transistors de sélection TS, un circuit de programmation PGRC2, un circuit de sélection MUX2 et huit circuits de lecture $SA_0$-$SA_7$.

Le plan mémoire 30 présente un entrelacement de bits tel que décrit par le tableau 2 figurant en Annexe, faisant partie intégrante de la description. Ce tableau décrit un entrelacement selon l'invention dans le cas où N=1, M=2, P=4, K=8. Les mots binaires $W_0$, $W_1$, $W_2$, $W_3$ mentionnés à titre d'exemple ont des adresses $0000_H$, $0001_H$, $0002_H$ et $0003_H$ respectivement, les mots $W_0$, $W_1$ d'une part et les mots $W_2$,$W_3$ d'autre part ayant la même adresse partielle. L'entrelacement des bits dans le plan mémoire 30 est effectué selon les règles suivantes :

1) chaque page mémoire, c'est-à-dire chaque ligne de mot $WL_0$, $WL_1$, $WL_2$, $WL_3$... est divisée en M sous-pages, ici deux sous-pages $SP_0$, $SP_1$,

2) les mots ayant la même adresse partielle sont agencés dans des sous-pages adjacentes. Par exemple, les mots $W_0$, $W_2$ sont agencés dans la sous-page $SP_0$ et les mots $W_1$, $W_3$ sont agencés dans la sous-page $SP_1$,

3) chaque sous-page comprend P groupes de cellules, soit ici quatre groupes $GP_0$ à $GP_3$ pour la sous-page $SP_0$ et quatre groupes $GP_4$ à $GP_7$ pour la sous-page $SP_1$,

4) chaque groupe est divisé en K/P sous-groupes de cellules, ici deux sous-groupes (K=8, P=4). Par exemple, le groupe $GP_0$ comprend deux sous-groupes $SGP_{00}$, $SGP_{01}$, le groupe $GP_1$ comprend deux sous-groupe $SGP_{10}$, $SGP_{11}$, etc.,

5) les bits de rang j et j+1 d'un même mot sont rangés dans des groupes adjacents d'une même sous-page. Par exemple, les bits $b_7$, $b_6$, $b_5$, $b_4$ du mot $W_0$ sont rangés dans les groupes $GP_0$, $GP_1$, $GP_2$, $GP_3$ de la sous-page $SP_0$ et les bits $b_7$ à $b_4$ du mot $W_1$ sont rangés dans les groupes $GP_4$ à $GP_7$ de la sous-page $SP_1$,

6) les bits de rang j et j+P, ici de rang j et j+4 sont rangés dans des sous-groupes adjacents d'un même groupe Par exemple, les bits $b_7$ des mots $W_0$, $W_2$... sont agencés dans le sous-groupe $SGP_{00}$ du groupe $GP_0$ et les bits $b_3$ des mots $W_0$, $W_2$... sont agencés dans le sous-groupe $SGP_{01}$,

7) enfin, chaque sous-groupe comprend des bits de même rang appartenant à des mots ayant des adresses présentant des sauts de valeur M, ici des sauts de valeur 2. Par exemple, le sous-groupe $SGP_{00}$ comprend le bit $b_7$ de chacun des mots $W_0$ et $W_2$.

En d'autres termes, les mots binaires ayant la même adresse partielle sont enregistrés dans des sous-pages adjacentes d'une même page et sont "repliés" dans chaque sous-page en P groupes de bits, le repliement consistant dans la prévision de K/P sous-groupes. En attribuant à chaque groupe de bits un circuit de lecture et un seul, comme on le verra ci-après, cet entrelacement permet de limiter le nombre de circuits de lecture.

Un tel entrelacement de bits est obtenu ici par la prévision dans le bloc mémoire 31 d'un chemin d'écriture spécifique qui sera décrit plus loin. Par ailleurs, le bloc mémoire 31 comprend un chemin de lecture en concordance avec l'entrelacement de bits, prévu pour délivrer sur application d'une adresse complète des groupes de P bits de M mots binaires ayant la même adresse partielle, ici des groupes de quatre bits.

Chemin de lecture :

Les cellules mémoire de chaque sous-groupe de bits $SGP_{00}$, $SGP_{01}$, $SGP_{10}$, $SGP_{11}$, $SGP_{20}$,...$SGP_{71}$ ont leurs lignes de bit reliées à une ligne commune, respectivement $L_{00}$, $L_{01}$, $L_{10}$, $L_{11}$, $L_{20}$, ... $L_{71}$ par l'intermédiaire d'un transistor de sélection TS du décodeur BDEC2. Les lignes $L_{00}$ à $L_{71}$ sont reliées à un seul et même circuit de lecture par l'intermédiaire du circuit de sélection MUX2. Celui-ci comprend des transistors $MT_{01}$, $MT_{11}$, $MT_{21}$... $MT_{71}$ pilotés par un signal AX et des transistors $MT_{00}$, $MT_{10}$, $MT_{20}$...$MT_{70}$ pilotés par un signal BX inverse du signal AX, délivré par une porte inverseuse. Les lignes communes rattachées à des sous-groupes de cellules d'un même groupe, ici les paires de lignes $L_{00}/L_{01}$, $L_{10}/L_{11}$,...$L_{70}/L_{71}$, sont reliées à un seul et même circuit de lecture, respectivement $SA_7$, $SA_6$,... $SA_0$ l'intermédiaire de transistors du circuit MUX2 fonctionnant en opposition de phase. Ainsi, les lignes $L_{00}/L_{01}$ sont reliées au circuit de lecture $A_7$ par les transistors $MT_{00}/MT_{01}$, les lignes $L_{10}/L_{11}$ sont reliées au circuit de lecture $A_6$ par les transistors $MT_{10}/MT_{11}$, etc..

Les connexions entre les sorties $SCL_0$, $SCL_1$,... du bloc de décodage CDEC2 et les transistors de sélection TS sont réalisées de manière que l'application d'une adresse donnée au bloc de décodage CDEC2 entraîne la sélection de toutes les lignes de bit du mot désigné par cette adresse, la séparation entre les bits de poids fort et les bits de poids faible étant assurée par les transistors MT du circuit MUX2, selon la valeur du signal AX.

Par ailleurs, pour que deux groupes de quatre bits de deux mots différents puissent être sélectionnés simultanément, le bloc de décodage CDEC2 est agencé pour activer simultanément en mode lecture deux sorties de même adresse partielle. Par exemple, les sorties $SLC_0$ et $SCL_1$ sont simultanément activées après application au bloc de décodage CDEC2 de l'adresse $0000_H$ ou de l'adresse $0001_H$. L'activation simultanée de toutes les sorties du bloc de décodage CDEC2 ayant la même adresse partielle peut être obtenue, comme suit: chaque entrée principale $A_0$, $A_1$,... du bloc de décodage CDEC2 comprend une entrée complémentaire $/A_0$, $/A_1$,... recevant l'inverse du bit d'adresse appliqué sur l'entrée principale. Cette caractéristique est en soi classique dans un décodeur. Selon l'invention, les entrées $A_0$ et $/A_0$ sont forcées à "1" en mode lecture par le signal READ, au moyen de deux portes "OU" recevant en entrée le signal READ et le bit $A_0$ ou $/A_0$. Ainsi, lorsqu'une adresse est appliquée au bloc de décodage CDEC2 et que le signal READ est à 1, les deux sorties du bloc de décodage CDEC2 de même adresse partielle sont simultanément activées, par exemple les sorties $SCL_0$, $SCL_1$ sur la figure 9.

Ainsi, si l'on se reporte de nouveau à la figure 9, on voit que l'application d'une adresse $A_{15}$-$A_0$ comprenant huit bits $A_{15}$-$A_8$ appliqués au décodeur ADEC2 et huit bits $A_7$-$A_0$ appliqués au bloc de décodage CDEC2 entraîne la sélection de toutes les lignes de bit des mots ayant la même adresse partielle $A_{15}$-$A_1$, la séparation entre les bits de poids fort et les bits de poids faible de chacun des mots étant assurée à l'entrée des circuits de lecture par les transistors MT du circuit MUX2. En pratique, l'application d'une adresse partielle $A_{15}$-$A_1$ suffit pour obtenir ce résultat puisque le bit de poids faible $A_0$ est inhibé par le signal READ. Par exemple, l'application d'une adresse partielle $A_{15}$-$A_1$ ayant tous ses bits à 0 déclenche la sélection simultanée des mots $W_0$ et $W_1$ d'adresses respectives $0000_H$ et $0001_H$. Les circuits de lecture $SA_7$-$SA_0$ délivrent les bits $b_7(W_0)$-$b_4(W_0)$ $b_7(W_1)$-$b_4(W_1)$ si le signal AX est à 0 ou délivrent les bits $b_3(W_0)$-$b_0(W_0)$ $b_3(W_1)$ - $b_0(W_1)$ si AX est à 1.

Chemin d'écriture :

Le circuit de programmation PGRC2 comprend autant de bascules à verrouillage que de sous-groupes de cellules, soit ici seize bascules $LT_{00}$, $LT_{10}$, $LT_{10}$, $LT_{11}$... $LT_{71}$. Chaque bascule est connectée en sortie à une ligne commune $L_{00}$, $L_{01}$, $L_{10}$, $L_{11}$... $L_{71}$ et en entrée à un fil du bus de données DB. Ce fil du bus de données est celui dont le rang correspond au rang des bits stockés dans le sous-groupe de cellules reliées à la ligne commune. Par exemple, la bascule $LT_{00}$ est connectée en entrée au fil "$b_7$" du bus DB (fil transportant les bits de rang 7) car sa sortie est connectée à la ligne commune $LT_{00}$ du sous-groupe $SGP_{00}$ comprenant les bits $b_7$ des mots d'adresse paire. Par ailleurs, les bascules LT affectées à des sous-groupes de même rang dans chaque sous-page sont connectées au même fil du bus de données DB. Par exemple, les bascules $LT_{00}$ et $LT_{40}$ sont toutes deux connectées au fil "b7" du bus DB car leurs sorties sont respectivement connectées aux lignes commune $L_{00}$ et $L_{40}$ des cellules des sous-groupes $SGP_{00}$ et $SGP_{40}$ contenant des bits $b_7$.

Au cours d'une opération de programmation de cellules, qui est toujours précédée de l'effacement de la page concernée ou de l'effacement simultané de plusieurs pages, toutes les bascules LT sont polarisées par la haute tension de drain Vppd et reçoivent en entrée les bits $b_7$-$b_0$ à programmer. La sélection des huit cellules mémoire recevant la tension Vppd est assurée par les transistors de sélection TS du décodeur BDEC2, qui sont agencés entre le circuit de programmation PGRC2 et le plan mémoire 30. Notons que cet agencement du circuit de programmation PGRC2 en amont des transistors de sélection TS du décodeur BDEC2 est dû au fait que la programmation simultanée de plusieurs mots n'est pas envisageable dans une mémoire FLASH, pour des raisons mentionnées plus haut. L'attribution d'une bascule à verrouillage LT à chaque ligne de bit, comme cela est le cas dans la mémoire EEPROM décrite plus haut, n'est donc pas envisageable ici.

**C/ Architecture d'une mémoire FLASH selon l'invention**

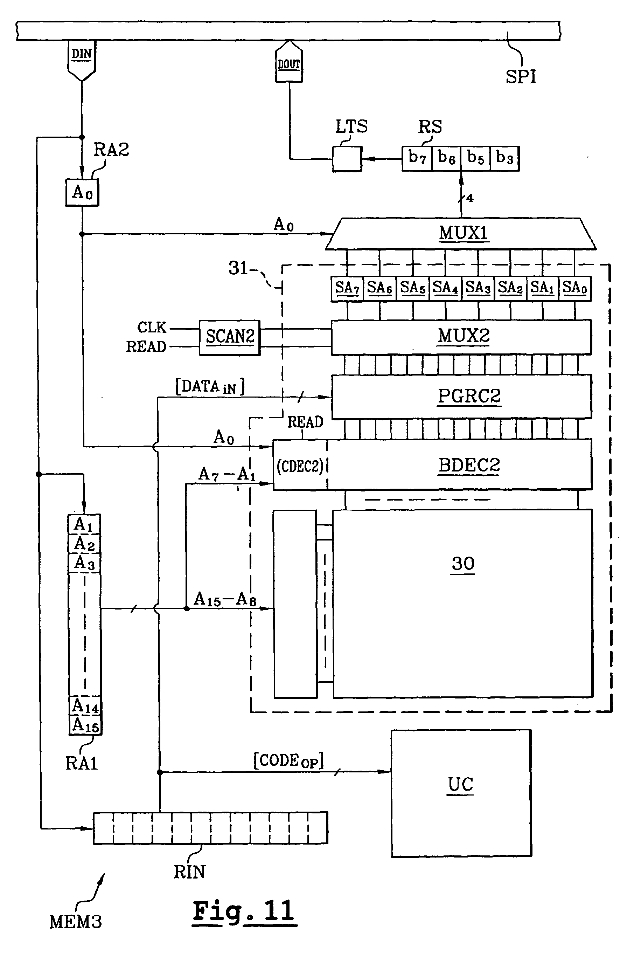

La figure 11 représente l'architecture d'une mémoire MEM3 selon l'invention, réalisée à partir du bloc mémoire 31 précédemment décrit et divers éléments périphériques. L'architecture de la mémoire MEM3 est sensiblement la même que celle de la mémoire MEM2. On retrouve les ports DIN, DOUT, les registres d'entrée RA1, RA2 (pour les adresses) et RIN (pour les données et les codes opération), le circuit de sélection MUX1 connecté à la sortie des circuits de lecture $SA_7$-$SA_1$, les registres de sortie RS, LS et l'unité centrale UC.

Le bit $A_0$ délivré par le registre RA2 est appliqué ici directement sur le décodeur BDEC2, le circuit SCAN1 étant supprimé. Le circuit SCAN1 est remplacé par un circuit de balayage SCAN2 qui délivre le signal AX pilotant le circuit de sélection MUX2 du bloc mémoire 31.

Le circuit SCAN2 comprend le diviseur 23 décrit plus haut, toujours un diviseur par 4, dont la sortie délivre le signal QCLK. Le signal QCLK est envoyé à la sortie du circuit SCAN2 par l'intermédiaire d'un transistor interrupteur SWT piloté par le signal READ. Ainsi, le signal AX en sortie du circuit SCAN2 recopie le signal QCLK pendant les périodes de lecture (READ=1). En dehors des périodes de lecture, le transistor SWT est fermé et le signal AX est à haute impédance, les transistors de sélection MT du circuit MUX2 restant ainsi bloqués.

Le fonctionnement de la mémoire MEM3 est similaire à celui de la mémoire MEM2. On se reportera aux explications données plus haut en relation avec les figures 7A à 7L, en considérant que le signal $A_0'$ est ici le signal AX.

**III-3/ Second mode de réalisation**

**A/ Architecture d'un bloc mémoire FLASH comprenant un entrelacement de bits selon l'invention**

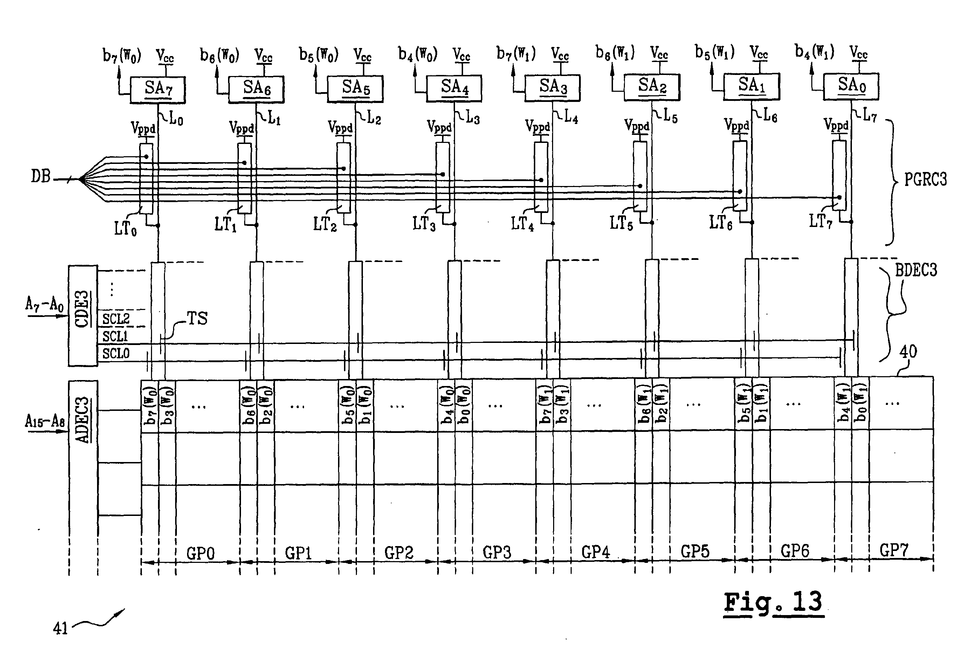

La figure 13 représente un bloc mémoire FLASH 41 comprenant comme le précédent un plan mémoire 40, un décodeur de ligne de mot ADEC3, un décodeur de ligne de bit BDEC3, un circuit de programmation PGRC3 ne comprenant que huit bascules à verrouillage $LT_0$ à $LT_7$ connectées en entrée à un bus de données DB, et huit circuits de lecture $SA_0$ à $SA_7$. Le plan mémoire 40 est identique au plan mémoire 30 précédemment décrit, les mots étant stockés conformément à l'entrelacement décrit par le tableau 2 en annexe.

Le bloc mémoire 41 se distingue du bloc mémoire 31 de la figure 9 par une architecture simplifiée, qui est en fait celle d'un bloc mémoire FLASH classique utilisé dans l'art antérieur pour stocker des mots dans huit groupes de cellules de rang croissant comprenant chacun des bits de même rang. Toutes les lignes de bit des cellules d'un même groupe $GP_0$, $GP_1$, ... $GP_7$ sont connectées à une ligne commune $L_0$, $L_1$,...$L_7$ par l'intermédiaire de transistors de sélection TS du décodeur BDEC3, et chaque ligne commune $L_0$ à $L_7$ est reliée à un circuit de lecture $SA_0$ à $SA_7$ sans le circuit multiplexeur MUX2 décrit plus haut. Par conséquent, deux cellules appartenant à deux sous-groupes SGP d'un même groupe GP ne sont pas différenciées et sont reliées au même circuit de lecture SA. Ici, la sélection des cellules de poids fort ou de poids faible présentes au sein des groupes (voir tableau 2) est assurée exclusivement par les transistors TS du décodeur BDEC3, chaque sortie $SCL_0$, $SCL_1$,... du bloc de décodage CDEC3 ne pilotant que huit transistors de sélection TS. Le chemin d'écriture du bloc mémoire 41 est également classique, chaque bascule à verrouillage $LT_0$, $LT_1$... $LT_8$ étant connectée en entrée à un fil du bus de données DB et en sortie à l'une des lignes communes $L_0$, $L_1$...$L_8$.

En définitive, l'architecture du bloc mémoire 41 ne permet pas de réaliser l'entrelacement des mots selon l'invention au stade de leur enregistrement. Cet entrelacement est obtenu ici par un moyen externe, qui envoie sur le bus de données DB du circuit de programmation des mots composites déjà entrelacés du type :

$$b_7(W_j) - b_4(W_j) \quad b_7(W_{j+1}) - b_4(W_{j+1})$$

ou du type :

$$b_3(W_j) - b_0(W_j) \quad b_3(W_{j+1}) - b_0(W_{j+1}).$$

Ainsi, les mots binaires originels sont "éclatés" en groupes de P bits se trouvant dans des mots composites d'adresses différentes. Il n'y a plus qu'une correspondance de fait entre l'adresse originelle d'un mot et son adresse physique dans la mémoire, le mot étant reconstitué en sortie du bloc mémoire par le processus de sélection des groupes de P bits et leur envoi sous forme de données série.

**B/ Architecture d'une mémoire FLASH selon l'invention**

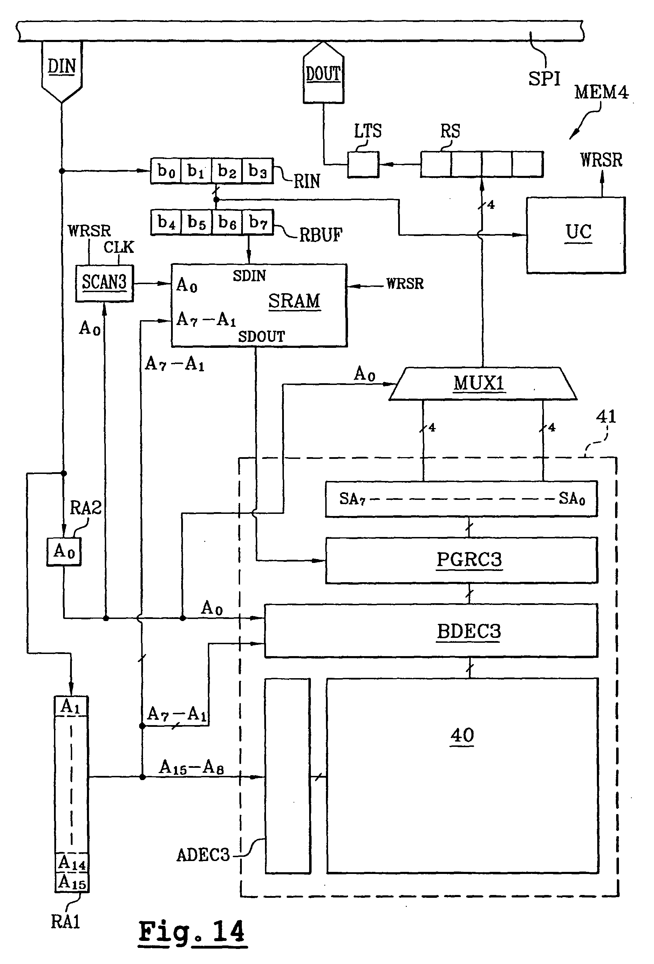

La figure 14 représente l'architecture d'une mémoire MEM4 réalisée à partir du bloc mémoire FLASH 41 et divers éléments périphériques déjà décrits dans ce qui précède, comme les ports DIN, DOUT, les registres d'entrée RA1, RA2 (pour les adresses) et RIN (pour les données et les codes opération), le circuit de sélection MUX1 connecté aux circuits de lecture $SA_7$-$SA_1$, les registres de sortie RS, LS et l'unité centrale UC. Le registre d'entrée RIN est ici un registre de 4 bits.

La mémoire FLASH MEM4 comprend, comme la mémoire EEPROM MEM2, le circuit SCAN1 activé ou inhibé par le signal READ, dont la sortie attaque l'entrée d'adresse $A_0$ du décodeur BDEC3 et délivre le bit cyclique $A_0$' pendant les opérations de lecture. La mémoire MEM4 fonctionne ainsi en lecture comme la mémoire MEM2, bien que les moyens mis en oeuvre pour arriver à ce résultat soient différents.

La mémoire MEM4 se distingue essentiellement des mémoires MEM2, MEM3 en ce qu'elle comprend des moyens d'entrelacement de mots externes au bloc mémoire 41, agencés sur le chemin de données de la mémoire MEM4, c'est-à-dire entre le port DIN et l'entrée du bloc mémoire 41. Ces moyens d'entrelacement externes comprennent une mémoire tampon volatile, ici une mémoire SRAM, dont la sortie SDOUT est connectée au bus de données DB du circuit de programmation PGRC3. L'entrée SDIN de la mémoire SRAM est reliée à la sortie parallèle du registre d'entrée RIN par l'intermédiaire d'un registre tampon RBUF de quatre bits. L'entrée d'adresse de la mémoire tampon SRAM reçoit les bits d'adresse $A_7$-$A_1$ délivrés par le registre $RA_1$ et reçoit le bit d'adresse de plus faible poids $A_0$ par l'intermédiaire d'un circuit SCAN3 dont la structure est identique à celle du circuit SCAN1, le circuit SCAN3 étant toutefois activé ou inhibé par un signal WRSR d'écriture de la mémoire SRAM au lieu d'être activé par le signal READ comme le circuit SCAN1.

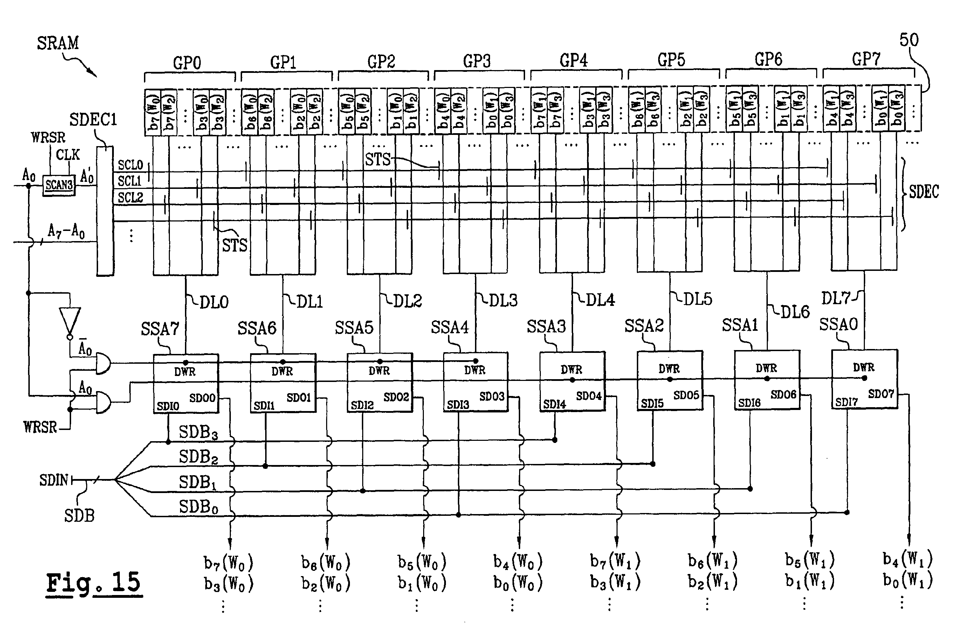

L'architecture de la mémoire SRAM est représentée en figure 15 et est soi classique. La mémoire SRAM comprend un plan mémoire 50, des circuits de lecture/écriture $SSA_0$ à $SSA_7$, un bus de données SDB connecté à l'entrée SDIN de la mémoire SRAM, comprenant quatre fils $SDB_0$ à $SDB_3$, et un décodeur d'adresse SDEC comprenant des transistors de sélection STS pilotés par un bloc de décodage SDEC1. Chaque circuit de lecture/écriture $SSA_0$ à $SSA_7$ comprend une entrée de déclenchement d'écriture DWR, une entrée de donnée $SDI_0$ à $SDI_7$, une sortie de donnée $SDO_0$ à $SDO_7$. Le plan mémoire 50 comprend de préférence autant de cellules mémoire volatile qu'il y a de cellules mémoire FLASH dans une page du plan mémoire FLASH 40. Les cellules sont agencées en huit groupes de cellules $GP_0$ à $GP_7$. Les cellules de chaque groupe $GP_0$ à $GP_7$ sont reliées à une ligne commune $DL_0$ à $DL_7$ par l'intermédiaire de transistors de sélection STS du décodeur SDEC, chaque ligne commune $DL_0$ à $DL_7$ étant connectée à l'un des circuits de lecture/écriture $SSA_0$ à $SSA_7$. L'agencement du décodeur SDEC est classique, les connexions entre les sorties $SCL_0$, $SCL_1$... du bloc de décodage SDEC2 et les transistors de sélection STS étant telle que l'application d'une adresse appliquée entraîne la sélection d'une cellule de chaque groupe.

Selon l'invention, les circuits de lecture/écriture de rang j+P, ici de rang j+4, sont connectés à un même fil du bus de données SDB. Ainsi, les circuit $SSA_7$ et $SSA_3$ sont connectés au fil SDB3, les circuit $SSA_6$ et $SSA_2$ sont connectés au fil SDB2, les circuit $SSA_5$ et $SSA_1$ sont connectés au fil SDB1, et les circuit $SSA_4$ et $SSA_0$ sont connectés au fil SDB0. Par ailleurs, les entrées DWR des circuits $SSA_7$ à $SSA_4$ reçoivent le signal d'écriture WRSR par l'intermédiaire d'une porte "ET" recevant sur son autre entrée l'inverse /$A_0$ du bit d'adresse de plus faible poids $A_0$, prélevé à la sortie du registre RA2. Les entrées DWR des circuits $SSA_3$ à $SSA_0$ reçoivent le signal d'écriture WRSR par l'intermédiaire d'une porte "ET" recevant sur son autre entrée le bit $A_0$. Ainsi, un groupe de 4 bits présenté sur l'entrée SDIN de la mémoire SRAM est enregistré dans des cellules des groupes $GP_0$ à $GP_3$ quand le bit $A_0$ est à 0 (adresse paire) et est enregistré dans des cellules des groupes $GP_4$ à $GP_7$ quand le bit $A_0$ est à 1 (adresse impaire).

Une opération d'écriture d'un mot sera maintenant décrite en se référant conjointement aux figures 14 et 15. L'opération d'écriture proprement dite commence après réception du code [$CODE_{OP}$] de l'instruction, de l'adresse $A_{15}$-$A_0$ d'enregistrement du mot, et réception des quatre premiers bits du mot dans le registre RA1. On suppose ici, à titre d'exemple, que le bit d'adresse $A_0$ est égal à 0. Le signal d'écriture WRSR est mis à 1, le circuit SCAN3 démarre et le bit $A_0$'est forcé à 0 pour une durée de quatre cycles d'horloge. Les quatre bits du mot sont transférés sur l'entrée SDIN de la mémoire SRAM au moyen du tampon RBUF pendant que le premier bit des quatre bits suivants est reçu. Le bit d'adresse $A_0$ étant égal à 0, le signal d'écriture WRSR est filtré par l'une des portes "ET" et ne parvient qu'aux circuits $SSA_7$ à $SSA_4$. Ainsi, les quatre premiers bits sont enregistrés dans des cellules des groupes $GP_7$ à $GP_4$ de la mémoire SRAM par les circuits $SSA_7$ à $SSA_4$ (fig. 15). Lorsque les quatre cycles d'horloge CLK sont expirés, les quatre bits suivant du mot sont transférés sur l'entrée SDIN pendant que le circuit SCAN3 met à 1 le bit $A_0$'. Le second groupe de bits est à nouveau enregistré dans des cellules des groupes $GP_7$ à $GP_4$ car le bit d'adresse $A_0$ est toujours égal à 0. Toutefois, l'adresse d'enregistrement est différente puisque le bit $A_0$' appliqué au décodeur d'adresse SDEC est maintenant à 1. Il s'agit de l'adresse impaire suivant immédiatement l'adresse paire d'enregistrement des quatre premiers bits.

Ces opérations sont effectuées sous le contrôle de l'unité centrale UC, qui délivre les signaux nécessaires. Au final, le mot est éclaté en deux groupes de bits enregistrés à deux adresses successives de la mémoire SRAM. Si un deuxième mot binaire d'adresse impaire ($A_0$=1) ayant la même adresse partielle que le premier, est enregistré dans la mémoire SRAM, les deux groupes de bits du second mot sont enregistrés dans des cellules des groupes $GP_3$ à $GP_0$ car le bit d'adresse $A_0$ est égal à 1. Au terme de l'enregistrement du deuxième mot, on trouve dans la mémoire deux mots composites d'adresses paire et impaire, chacun comprenant quatre bits de poids fort ou faible des deux mots originels.

En définitive, la mémoire SRAM présente un entrelacement de bits conforme à celui décrit par le tableau 2 en annexe. Lorsque plusieurs mots sont enregistrés successivement dans la mémoire SRAM, l'unité centrale UC les transfère ensuite les uns après les autres dans le bloc mémoire FLASH 41, par des étapes successives de lecture de la mémoire SRAM et d'écriture du bloc mémoire FLASH. Chaque étape de transfert s'effectue en appliquant la même adresse de poids faible $A_7$-$A_0$ à la mémoire SRAM et au décodeur BDEC3 du bloc mémoire FLASH. Les mots lus étant des mots composites, l'entrelacement présent dans la mémoire SRAM est transféré tel quel dans le bloc mémoire FLASH.

Ce mode de réalisation de la présente invention présente divers avantages. D'une part, il permet de mettre en oeuvre le procédé de l'invention au moyen d'un bloc mémoire FLASH conventionnel pouvant être choisi dans une bibliothèque de circuits intégrés standards. En pratique, la réalisation d'une mémoire tampon SRAM du type susmentionné peut s'avérer plus simple que le fait de devoir réaliser un bloc mémoire FLASH spécifique comme celui de la mémoire MEM3 décrite plus haut. Un autre avantage de ce mode de réalisation est de permettre l'enregistrement séquentiel d'une suite de mot dans la mémoire tampon, avant le transfert des mots dans le bloc mémoire FLASH. La mémoire tampon permet ainsi de simuler le mode page des mémoires EEPROM, ce que les mémoires FLASH classiques ne peuvent pas faire ni la mémoire MEM3 décrite plus haut. Toutefois, la mémoire MEM3 pourra être préférée à la mémoire MEM4 dans des applications où le mode page n'est pas utile.

La mémoire tampon selon l'invention est bien entendu susceptible de diverses variantes de réalisation. Elle peut par exemple ne comprendre que 16 cellules mémoire pour l'enregistrement de deux mots binaire sous forme de deux mots composites, si un fonctionnement en mode page n'est pas souhaité.

D'autre part, l'entrelacement des mots binaires peut être effectué d'une autre manière. Ainsi, dans une variante, les mots binaires sont enregistrés normalement dans la mémoire tampon et sont entrelacés au moment de leur transfert dans le bloc mémoire FLASH. A cet effet, un circuit mélangeur est prévu entre la sortie de la mémoire tampon et l'entrée du bloc mémoire FLASH. Le circuit mélangeur comprend par exemple deux registres tampons de 8 bits chacun, recevant les deux mots à entrelacer, dont les sorties sont entrelacées et appliquées à l'entrée du bloc mémoire FLASH par l'intermédiaire d'un circuit multiplexeur. Le circuit multiplexeur est piloté par un circuit de balayage de même structure que le circuit SCAN3.

### IV - Synthèse des modes de réalisation décrits

On a décrit dans ce qui précède trois modes de réalisation détaillés d'une mémoire série à lecture par anticipation, ne nécessitant que K circuits de lecture pour lire des mots de K bits (contre M fois K circuits de lecture dans les mémoires à lecture par anticipation de l'art antérieur). La première mémoire MEM2 comprend un bloc mémoire ayant un chemin de lecture spécifique, délivrant des mots composites à partir de mots enregistrés sans entrelacement. La deuxième mémoire MEM3 comprend un bloc mémoire pourvu d'un chemin d'écriture spécifique assurant l'entrelacement des mots au moment de leur enregistrement, et un chemin de lecture approprié à la lecture de mots composites. La troisième mémoire MEM4 comprend un bloc mémoire FLASH standard pourvu d'une mémoire tampon assurant la transformation de mots reçus en mots composites avant leur enregistrement dans le bloc mémoire et/ou la simulation du mode de programmation par page, l'entrelacement des mots pouvant également être assuré par des moyens mélangeurs agencés entre la sortie de la mémoire tampon et l'entrée du bloc mémoire FLASH.

De façon générale, des modes de réalisation sont susceptibles de diverses variantes et combinaisons. De plus, bien que la présente description ait été faite en relation avec des structures de mémoires EEPROM et FLASH, il va de soi que la présente invention est applicable à diverses autres sortes de mémoires. La présente invention est applicable notamment aux mémoires PROM qui sont, en raison de leur structure, à mi-chemin entre les mémoires FLASH et les mémoires EEPROM.

# ANNEXE

## Tableau 2 : entrelacement de bits et de mots selon l'invention

| SOUS-PAGE SP0 | | | | | | | | SOUS-PAGE SP1 | | | | | | | |
|---|---|---|---|---|---|---|---|---|---|---|---|---|---|---|---|
| Groupe GP0 | | Groupe GP1 | | Groupe GP2 | | Groupe GP3 | | Groupe GP4 | | Groupe GP5 | | Groupe GP6 | | Groupe GP7 | |
| SGP00 | SGP01 | SGP10 | SGP11 | SGP20 | SGP21 | SGP30 | SGP31 | SGP40 | SGP41 | SGP50 | SGP51 | SGP60 | SGP61 | SGP70 | SGP71 |
| b7(W0) b7(W2) . | b3(W0) b3(W2) . | b6(W0) b6(W2) . | b2(W0) b2(W2) . | b5(W0) b5(W2) . | b1(W0) b1(W2) . | b4(W0) b4(W2) . | b0(W0) b0(W2) . | b7(W1) b7(W3) . | b3(W1) b3(W3) . | b6(W1) b6(W3) . | b2(W1) b2(W3) . | b5(W1) b5(W3) . | b1(W1) b1(W3) . | b4(W1) b4(W3) . | b0(W1) b0(W3) . |
| b7(Wi) b7(Wi+2) . | b3(Wi) b3(Wi+2) . | b6(Wi) b6(Wi+2) . | b2(Wi) b2(Wi+2) . | b5(Wi) b5(Wi+2) . | b1(Wi) b1(Wi+2) . | b4(Wi) b4(Wi+2) . | b0(Wi) b0(Wi+2) . | b7(Wi+1) b7(Wi+3) . | b3(Wi+1) b3(Wi+3) . | b6(Wi+1) b6(Wi+3) . | b2(Wi+1) b2(Wi+3) . | b5(Wi+1) b5(Wi+3) . | b1(Wi+1) b1(Wi+3) . | b4(Wi+1) b4(Wi+3) . | b0(Wi+1) b0(Wi+3) . |

EP 1 172 820 B1

16

**Revendications**

1. Procédé de lecture d'un mot binaire ($W_j$) dans une mémoire à entrée et sortie série (MEM1-MEM4), comprenant une première étape de lecture de données dans la mémoire sur réception série d'une adresse partielle de lecture à laquelle il manque N bits de poids faible pour former une adresse complète, **caractérisé en ce que:** la première étape de lecture comprend les étapes consistant à :

   - lire simultanément les P premiers bits de M mots de la mémoire ayant la même adresse partielle,
   - lorsque l'adresse complète est reçue, sélectionner les P premiers bits du mot désigné par l'adresse complète et délivrer ces bits sur la sortie série de la mémoire; et **en ce que** le procédé comprend une seconde étape de lecture consistant à :

   - lire P bits suivants du mot désigné par l'adresse complète pendant la délivrance des P premiers bits et délivrer les P bits suivants sur la sortie série de la mémoire lorsque les P premiers bits sont délivrés.

2. Procédé selon la revendication 1, **caractérisé en ce que** la lecture de P bits suivants est effectuée comme la lecture des P premiers bits, en lisant simultanément P bits suivants des M mots de la mémoire ayant la même adresse partielle et en sélectionnant les P bits suivants du mot désigné par l'adresse complète.

3. Procédé selon l'une des revendications 1 et 2, applicable à une mémoire (21, MEM2) dans laquelle les cellules mémoire sont agencées en lignes de mot et en lignes de bit et les lignes de bit agencées en colonnes ($COL_0$, $COL_1$), **caractérisé en ce qu'**il comprend une étape consistant à prévoir dans la mémoire :

   - un décodeur d'adresse (BDEC1) agencé pour sélectionner simultanément, après application au décodeur d'une adresse complète, P lignes de bit de M colonnes différentes ($COL_0$, $COL_1$), et
   - un bus d'interconnexion (RB) agencé pour relier chacune des P lignes de bit sélectionnées à un circuit de lecture ($SA_0$-$SA_7$).

4. Procédé selon la revendication 3, **caractérisé en ce que** la première étape de lecture est effectuée en appliquant au décodeur l'adresse partielle reçue, et en balayant (SCAN1) sur les entrées d'adresse de poids faible du décodeur les $2^N$ combinaisons possibles des N derniers bits d'adresse.

5. Procédé selon l'une des revendications 1 et 2, applicable à une mémoire (31, 41, MEM3, MEM4, SRAM) comprenant des cellules agencées en lignes de mot et en lignes de bit, une ligne de mot formant une page mémoire, **caractérisé en ce qu'**il comprend une étape préliminaire consistant à (tableau 2):

   - enregistrer M mots de même adresse partielle dans M sous-pages adjacentes d'une page mémoire,
   - enregistrer chaque mot dans P groupes adjacents de cellules comprenant chacun K/P sous-groupes adjacents de cellules, K étant le nombre de bits de chaque mot, et
   - enregistrer des bits de rang j et j+1 d'un mot dans des groupes de cellules adjacents, et des bits de rang j et j+P d'un mot dans des sous-groupes de cellules adjacents, de telle sorte que les mots sont repliés dans les sous-pages.

6. Procédé selon la revendication 5, **caractérisé en ce que** l'étape de lecture comprend :

   - une étape de présélection (BDEC2) consistant à sélectionner simultanément en lecture, dans chaque groupe de cellules de chaque sous-page de la mémoire (31, MEM3), toutes les cellules contenant les bits des M mots ayant la même adresse partielle, et
   - une étape de sélection (MUX2) consistant à connecter à un circuit de lecture ($SA_7$-$SA_0$) les cellules contenant l'un des P bits visés de chacun des M mots.

7. Procédé selon l'une des revendications 1 à 6, **caractérisé en ce que** P est égal à K/M, K étant le nombre de bits que comprennent les mots stockés dans la mémoire, M étant égal à $2^N$.

8. Procédé selon l'une des revendications 1 à 7, **caractérisé en ce que** N est égal à 1 et M égal à 2.

9. Procédé selon l'une des revendications 1 à 8, **caractérisé en ce que** les P premiers bits de chacun des mots lus simultanément dans la mémoire sont des bits de poids fort.

**10.** Mémoire en circuit intégré (MEM1-MEM4) à entrée (DIN) et sortie (DOUT) série, **caractérisée en qu'**elle comprend des moyens (BDEC1, RB, BDEC2, MUX2, BDEC3, MUX1 $SA_7$-$SA_1$) pour, sur réception série d'une adresse partielle de lecture ($A_{15}$-$A_1$) à laquelle il manque N bits de poids faible pour former une adresse complète :

- lire simultanément les P premiers bits ($b_7$-$b_4$) de M mots de la mémoire ayant la même adresse partielle,
- lorsque l'adresse complète est reçue, sélectionner les P premiers bits du mot désigné par l'adresse complète et délivrer ces bits sur la sortie série, et
- lire P bits suivants ($b_3$-$b_0$) du mot désigné par l'adresse complète pendant la délivrance des P premiers bits et délivrer ces bits sur la sortie série lorsque les P premiers bits sont délivrés.

**11.** Mémoire selon la revendication 10, **caractérisé en ce qu'**elle comprend des moyens (MUX1) de sélection d'un groupe de P bits parmi M groupes de P bits lus simultanément, recevant sur une entrée de commande les N bits de poids faible ($A_0$) de l'adresse complète.

**12.** Mémoire (21, MEM2) selon l'une des revendications 10 et 11, comprenant des cellules mémoire agencées en lignes de mot et en lignes de bit, les lignes de bit étant agencées en colonnes ($COL_0$, $COL_1$), un décodeur d'adresse (BDEC1) pour sélectionner des lignes de bit et un bus d'interconnexion (RB) pour relier des lignes de bit sélectionnées à des circuits de lecture ($SA_7$-$SA_0$) **caractérisée en ce que** :

- le décodeur d'adresse est agencé pour sélectionner simultanément P lignes de bit de M colonnes différentes de même adresse partielle, et
- le bus d'interconnexion est agencé pour relier chacune des P lignes de bit sélectionnées à un circuit de lecture.

**13.** Mémoire selon la revendication 12, **caractérisée en ce qu'**elle comprend un circuit de balayage d'adresse (SCAN1) agencé pour balayer, pendant une opération de lecture d'un mot, les $2^N$ combinaisons possibles des N bits de poids faible ($A_0$) d'une adresse appliquée au décodeur d'adresse.

**14.** Mémoire (31, 41, MEM3, MEM4, SRAM) selon l'une des revendications 10 et 11, comprenant des cellules mémoire agencées en lignes de mot et en lignes de bit, une ligne de mot formant une page mémoire, **caractérisée en ce qu'**elle comprend des moyens d'entrelacement de bits agencés pour (tableau 2) :

- enregistrer M mots de même adresse partielle dans M sous-pages adjacentes d'une page mémoire,
- enregistrer chaque mot dans P groupes adjacents de cellules comprenant chacun K/P sous-groupes adjacents de cellules, K étant le nombre de bits de chaque mot, et
- enregistrer des bits de rang j et j+1 d'un mot dans des groupes de cellules adjacents, et des bits de rang j et j+P d'un mot dans des sous-groupes de cellules adjacents, de telle sorte que les mots sont repliés dans les sous-pages.

**15.** Mémoire (31, MEM3) selon la revendication 14, comprenant un décodeur d'adresse (BDEC2) comprenant des interrupteurs (TS) de sélection de ligne de bit, un circuit (PGRC2) de programmation de la mémoire comprenant des bascules à verrouillage (LT) connectées en entrée à un bus de données (DB) comprenant K fils, **caractérisé en ce que** :

- le circuit (PGRC2) de programmation comprend M fois K bascules à verrouillage (LT),
- les lignes de bit (BL) d'un même sous-groupe de cellules (SGP) sont reliées à une ligne commune (L) par l'intermédiaire d'interrupteurs de sélection (TS),
- chaque ligne commune est connectée à la sortie d'une bascule à verrouillage (LT), et
- les bascules à verrouillage ($LT_{00}$, $LT_{40}$) connectées en sortie à des sous-groupes de cellules de même rang appartenant à des sous-pages différentes, sont connectées à un même fil ($b_7$) du bus de données.

**16.** Mémoire selon la revendication 15, **caractérisée en ce que** le décodeur d'adresse (BDEC2) comprend des moyens d'inhibition (READ) en mode lecture de ses N entrées d'adresse de poids faible ($A_0$), pour sélectionner simultanément toutes les lignes de bit correspondant aux bits de tous les mots de la mémoire ayant la même adresse partielle.

**17.** Mémoire selon la revendication 16, **caractérisée en ce que** les lignes communes des sous-groupes de cellules d'un même groupe de cellules sont reliées à un même circuit de lecture ($SA_7$-$SA_0$) par l'intermédiaire d'un circuit multiplexeur (MUX2) agencé pour connecter au circuit de lecture une seule ligne commune à la fois, désignée par un signal (AX) de commande du circuit multiplexeur.

**18.** Mémoire selon la revendication 17, **caractérisée en ce que** le moyen de multiplexage (MUX2) est piloté par un circuit de balayage (SCAN2) agencé pour balayer au cours d'une opération de lecture d'un mot toutes les valeurs de multiplexage du signal de commande (AX), de telle sorte que les lignes communes de chaque sous-groupe d'un même groupe de cellules sont connectées au circuit de lecture les unes après les autres.

**19.** Mémoire (MEM4) selon l'une des revendications 10, 11, 14, comprenant un bloc mémoire (41) et des éléments périphériques au bloc mémoire, **caractérisée en ce qu'**elle comprend des moyens d'entrelacement de bits (SRAM) disposés entre l'entrée série (DIN) et l'entrée du bloc mémoire (41) et agencés pour présenter à l'entrée du bloc mémoire des mots composites comprenant M groupes de P bits de M différents mots binaires.

**20.** Mémoire selon l'une des revendications 10, 11, 14, 19, **caractérisée en ce qu'**elle comprend une mémoire tampon (SRAM) de type volatile dont la sortie est reliée à l'entrée du bloc mémoire (41), et des moyens (UC) pour enregistrer dans la mémoire tampon des données devant être enregistrées dans le bloc mémoire, puis enregistrer dans le bloc mémoire les données préalablement enregistrées dans la mémoire tampon.

**21.** Mémoire selon la revendication 20, **caractérisée en ce qu'**elle comprend des moyens (SCAN3, $SSA_7$-$SSA_0$) pour enregistrer dans la mémoire tampon des mots composites comprenant M groupes de P bits de M différents mots binaires reçus sous forme série.

**22.** Mémoire selon l'une des revendications 10 à 21, dans laquelle P est égal à K/M, K étant le nombre de bits que comprennent les mots stockés dans la mémoire, M étant égal à $2^N$.

**23.** Mémoire selon l'une des revendications 10 à 23, dans laquelle N est égal à 1 et M égal à 2.

**Claims**

**1.** A method for reading a binary word ($W_j$) in a serial input and output memory (MEM1-MEM4), comprising a first step of reading data in the memory upon serially receiving a partial read address from which N least significant bits are missing to form a full address, **characterized in that** the first reading step comprises the steps of:

- simultaneously reading the first P bits of M words of the memory having the same partial address,
- when the full address is received, selecting the first P bits of the word designated by the full address and delivering these bits on the serial output of the memory;

and **in that** the method comprises a second reading step of:

- reading the next P bits of the word designated by the full address during the delivery of the first P bits and delivering the next P bits on the serial output of the memory when the first P bits are delivered.

**2.** Method according to claim 1, **characterized in that** the next P bits are read in the same way as the first P bits, by simultaneously reading the next P bits of the M words of the memory having the same partial address and by selecting the next P bits of the word designated by the full address.

**3.** Method according to one of claims 1 and 2, applicable to a memory (21, MEM2) wherein the memory cells are arranged in word lines and in bit lines and the bit lines are arranged in columns ($COL_0$, $COL_1$), **characterized in that** it comprises a step of providing in the memory:

- an address decoder (BDEC1) arranged for simultaneously selecting, after applying a full address to the decoder, P bit lines of M different columns ($COL_0$, $COL_1$), and
- an interconnection bus (RB) arranged for linking each of the P bit lines selected to a sense amplifier ($SA_0$-$SA_7$).

**4.** Method according to claim 3, **characterized in that** the first reading step is performed by applying the partial address received to the decoder, and by scanning (SCAN1) over the least significant address inputs of the decoder the $2^N$ possible combinations of the N last address bits.

**5.** Method according to one of claims 1 and 2, applicable to a memory (31, 41, MEM3, MEM4, SRAM) comprising cells arranged in word lines and in bit lines, one word line forming one memory page, **characterized in that** it comprises a preliminary step of (table 2):

- recording M words of a same partial address in M adjacent sub-pages of a memory page,
- recording each word in P adjacent groups of cells each comprising K/P adjacent subgroups of cells, K being the number of bits of each word, and
- recording bits of rank j and j+1 of a word in adjacent groups of cells, and bits of rank j and j+P of a word in adjacent subgroups of cells, such that the words are folded in the sub-pages.

6. Method according to claim 5, **characterized in that** the reading step comprises:

- a pre-selection step (BDEC2) of simultaneously read selecting, in each group of cells of each sub-page of the memory (31, MEM3), all the cells containing the bits of the M words having the same partial address, and
- a selection step (MUX2) of connecting to a sense amplifier ($SA_7$-$SA_0$) the cells containing one of the P targeted bits of each of the M words.

7. Method according to one of claims 1 to 6, **characterized in that** P is equal to K/M, K being the number of bits comprised in the words stored in the memory, M being equal to $2^N$.

8. Method according to one of claims 1 to 7, **characterized in that** N is equal to 1 and M equal to 2.

9. Method according to one of claims 1 to 8, **characterized in that** the first P bits of each word read simultaneously in the memory are most significant bits.

10. A serial input (DIN) and output (DOUT) integrated circuit memory (MEM1-MEM4), **characterised in that** it comprises means (BDEC1, RB, BDEC2, MUX2, BDEC3, MUX1, $SA_7$-$SA_1$) for, upon serially receiving a partial read address ($A_{15}$-$A_1$) from which N least significant bits are missing to form a full address:

- simultaneously reading the first P bits ($b_7$-$b_4$) of M words of the memory having the same partial address,
- when the full address is received, selecting the first P bits of the word designated by the full address and delivering these bits on the serial output, and
- reading the next P bits ($b_3$-$b_0$) of the word designated by the full address during the delivery of the first P bits, and delivering these bits on the serial output when the first P bits are delivered.

11. Memory according to claim 10, **characterized in that** it comprises means (MUX1) for selecting a group of P bits out of M groups of P bits read simultaneously, receiving on a control input the N least significant bits ($A_0$) of the full address.

12. Memory (21, MEM2) according to one of claims 10 and 11, comprising memory cells arranged in word lines and in bit lines, the bit lines being arranged in columns ($COL_0$, $COL_1$), an address decoder (BDEC1) for selecting bit lines and an interconnection bus (RB) for linking selected bit lines to sense amplifiers ($SA_7$-$SA_0$), **characterized in that**:

- the address decoder is arranged for simultaneously selecting P bit lines of M different columns of a same partial address, and
- the interconnection bus is arranged for linking each of the P selected bit lines to a sense amplifier.

13. Memory according to claim 12, **characterized in that** it comprises an address scanning circuit (SCAN1) arranged for scanning, during an operation of reading a word, the $2^N$ possible combinations of the N least significant bits ($A_0$) of an address applied to the address decoder.

14. Memory (31, 41, MEM3, MEM4, SRAM) according to one of claims 10 and 11, comprising memory cells arranged in word lines and in bit lines, one word line forming one memory page, **characterized in that** it comprises means for interleaving bits arranged for (table 2):

- recording M words of a same partial address in M adjacent sub-pages of a memory page,
- recording each word in P adjacent groups of cells each comprising K/P adjacent subgroups of cells, K being the number of bits of each word, and
- recording bits of rank j and j+1 of a word in adjacent groups of cells, and bits of rank j and j+P of a word in adjacent subgroups of cells, such that the words are folded in the sub-pages.

**15.** Memory (31, MEM3) according to claim 14, comprising an address decoder (BDEC2) comprising bit line selection switches (TS), a circuit (PGRC2) for programming the memory comprising latches (LT) connected at input to a data bus (DB) comprising K wires, **characterized in that**:

- the programming circuit (PGRC2) comprises M times K latches (LT),
- the bit lines (BL) of a same sub-group of cells (SGP) are linked to a common line (L) through selection switches (TS),
- each common line is connected to the output of a latch (LT), and
- the latches ($LT_{00}$, $LT_{40}$) connected at output to subgroups of cells of a same rank belonging to different sub-pages, are connected to a same wire ($b_7$) of the data bus.

**16.** Memory according to claim 15, **characterized in that** the address decoder (BDEC2) comprises means (READ) for inhibiting in read mode its N least significant address inputs ($A_0$), to simultaneously select all the bit lines corresponding to the bits of all the words of the memory having the same partial address.

**17.** Memory according to claim 16, **characterized in that** the common lines of the subgroups of cells of a same group of cells are linked to a same sense amplifier ($SA_7$-$SA_0$) through a multiplexer circuit (MUX2) arranged for connecting to the sense amplifier a single common line at a time, designated by a signal (AX) for controlling the multiplexer circuit.

**18.** Memory according to claim 17, **characterized in that** the multiplexing means (MUX2) is driven by a scanning circuit (SCAN2) arranged for scanning during an operation of reading a word all the multiplexing values of the control signal (AX), such that the common lines of each sub-group of a same group of cells are connected to the sense amplifier one after the other.

**19.** Memory (MEM4) according to one of claims 10, 11, 14, comprising a memory block (41) and elements peripheral to the memory block, **characterized in that** it comprises bit interleaving means (SRAM) arranged between the serial input (DIN) and the input of the memory block (41) and arranged for presenting at the input of the memory block composite words comprising M groups of P bits of M different binary words.

**20.** Memory according to one of claims 10, 11, 14, 19, **characterized in that** it comprises a volatile-type buffer memory (SRAM) the output of which is linked to the input of the memory block (41), and means (UC) for recording in the buffer memory data that must be recorded in the memory block, then recording in the memory block the data first recorded in the buffer memory.

**21.** Memory according to claim 20, **characterized in that** it comprises means (SCAN3, $SSA_7$-$SSA_0$) for recording in the buffer memory composite words comprising M groups of P bits of M different binary words received in serial form.

**22.** Memory according to one of claims 10 to 21, wherein P is equal to K/M, K being the number of bits comprised in the words stored in the memory, M being equal to $2^N$.

**23.** Memory according to one of claims 10 to 23, wherein N is equal to 1 and M equal to 2.

**Patentansprüche**

**1.** Verfahren zum Lesen eines Binärwortes ($W_j$) in einem Speicher mit seriellem Ein- und Ausgang (MEM1 - MEM4), einen ersten Schritt des Lesens von Daten im Speicher nach seriellem Empfang einer partiellen Leseadresse, der N niederwertige Bits fehlen, um eine vollständige Adresse zu bilden, umfassend, **dadurch gekennzeichnet, dass** der erste Leseschritt die folgenden Schritte umfasst:

- gleichzeitiges Lesen der P ersten Bits von M Wörtern des Speichers, die dieselbe partielle Adresse haben,
- nach Empfang der vollständigen Adresse, Auswählen der P ersten Bits des Wortes, das mit der ersten vollständigen Adresse bezeichnet wird, und Ausgabe dieser Bits am seriellen Ausgang des Speichers, und dadurch, dass das Verfahren einen zweiten Leseschritt umfasst, darin bestehend,
- P folgende Bits des durch die vollständige Adresse bezeichneten Wortes während der Ausgabe der P ersten Bits zu lesen und die P folgenden Bits am seriellen Ausgang des Speichers auszugeben, wenn die P ersten Bits ausgegeben worden sind.

**2.** Verfahren nach Patentanspruch 1, **dadurch gekennzeichnet, dass** das Lesen der P folgenden Bits wie das Lesen der P ersten Bits erfolgt, indem gleichzeitig P folgende Bits der M Wörter des Speichers gelesen werden, die dieselbe partielle Adresse haben und indem die P folgenden Bits des mit der vollständigen Adresse bezeichneten Wortes ausgewählt werden.

**3.** Verfahren nach einem der Patentansprüche 1 und 2, anwendbar auf einen Speicher (21, MEM2), in dem die Speicherzellen in Wortzeilen und in Bitzeilen angeordnet sind und die Bitzeilen in Spalten ($COL_0$, $COL_1$) angeordnet sind, **dadurch gekennzeichnet, dass** es einen Schritt enthält, darin bestehend, dass im Speicher Folgendes vorgesehen wird:

- ein Adressendecoder (BDEC1), der derart angeordnet ist, dass er gleichzeitig nach Anlegen einer vollständigen Adresse an den Decoder P Bitzeilen zu M verschiedenen Spalten ($COL_0$, $COL_1$) auswählt, und
- ein Verbindungsbus (RB), derart angeordnet, dass er jede der P ausgewählten Bitzeilen mit einer Leseschaltung ($SA_0$ - $SA_7$) verbindet.

**4.** Verfahren nach Patentanspruch 3, **dadurch gekennzeichnet, dass** der erste Leseschritt dadurch erfolgt, dass an den Decoder die empfangene partielle Adresse angelegt wird und indem an den niederwertigen Adresseneingängen des Decoders die $2^N$ möglichen Kombinationen der N letzten Adressenbits durchlaufen werden.

**5.** Verfahren nach einem der Patentansprüche 1 und 2, anwendbar auf einen Speicher (31, 41, MEM3, MEM4, SRAM), in dem die Speicherzellen in Wortzeilen und in Bitzeilen angeordnet sind, wobei eine Wortzeile eine Speicherseite bildet, **dadurch gekennzeichnet, dass** es einen vorangehenden Schritt enthält, darin bestehend (Tabelle 2),

- M Wörter derselben partiellen Adresse in M aneinander anschließende Unterseiten einer Speicherseite zu speichern,
- jedes Wort in P aneinander anschließende Gruppen von Zellen zu speichern, die jeweils K/P aneinander anschließende Untergruppen von Zellen umfassen, wobei K die Anzahl der Bits jedes Wortes ist, und
- Bits vom Rang j und j + 1 eines Wortes in aneinander anschlie-ßende Zellengruppen zu speichern, und Bits vom Rang j und j + P eines Wortes in aneinander anschließende Untergruppen von Zellen, derart, dass die Wörter in den Unterseiten umgefaltet sind.

**6.** Verfahren nach Patentanspruch 5, **dadurch gekennzeichnet, dass** der Leseschritt umfasst:

- einen Vorauswahlschritt (BDEC2), der darin besteht, gleichzeitig in jeder Zellengruppe jeder Unterseite des Speichers (31, MEM3) alle Zellen zum Lesen auszuwählen, die die Bits von M Wörtern mit derselben partiellen Adresse enthalten, und
- und einen Auswahlschritt (MUX2), der darin besteht, an eine Leseschaltung ($SA_7$ - $SA_0$) die Zellen anzuschlie-ßen, die eins der P Zielbits jedes der M Wörter enthalten.

**7.** Verfahren nach einem der Patentansprüche 1 bis 6, **dadurch gekennzeichnet, dass** P gleich K/M ist, wobei K die Anzahl an Bits ist, die die im Speicher gespeicherten Wörter umfassen, während M gleich $2^N$ ist.

**8.** Verfahren nach einem der Patentansprüche 1 bis 7, **dadurch gekennzeichnet, dass** N gleich 1 ist und M gleich 2.

**9.** Verfahren nach einem der Patentansprüche 1 bis 8, **dadurch gekennzeichnet, dass** die P ersten Bits jedes der gleichzeitig im Speicher gelesenen Wörter höherwertige Bits sind.

**10.** Speicher in einer integrierten Schaltung (MEM1 - MEM4) mit seriellem Ein- (DIN) und Ausgang (DOUT), **dadurch gekennzeichnet, dass** er Mittel (BDEC1, RP, BDEC2, MUX2, BDEC3, MUX1, $SA_7$ - $SA_1$) umfasst, um nach seriellem Empfang einer partiellen Leseadresse ($A_{15}$-$A_1$), in der N niederwertige Bits fehlen, um eine vollständige Adresse zu bilden,

- gleichzeitig die P ersten Bits ($b_7$- $b_4$) von M Wörtern des Speichers mit derselben partiellen Adresse zu lesen,
- nach Empfang der vollständigen Adresse die P ersten Bits des Wortes, das mit der vollständigen Adresse bezeichnet wird, auszuwählen und diese Bits am seriellen Ausgang auszugeben, und
- P folgende Bits ($b_3$- $b_0$) des Wortes, das durch die vollständige Adresse bezeichnet wird, während der Ausgabe der P ersten Bits zu lesen und diese Bits am seriellen Ausgang auszugeben, wenn die P ersten Bits ausgegeben sind.

**11.** Speicher nach Patentanspruch 10, **dadurch gekennzeichnet, dass** er Mittel (MUX1) zu Auswahl einer Gruppe von P Bits unter M Gruppen zu P Bits umfasst, die gleichzeitig gelesen wurden, die an einem Befehlseingang die N niederwertigen Bits ($A_0$) der vollständigen Adresse empfangen.

**12.** Speicher (21, MEM2) nach einem der Patentansprüche 10 und 11, Speicherzellen umfassend, die in Wortzeilen und in Bitzeilen angeordnet sind, wobei die Bitzeilen in Spalten ($COL_0$, $COL_1$) angeordnet sind, einen Adressendecoder (BDEC1) zur Auswahl der Bitzeilen und einen Verbindungsbus (RB), um ausgewählte Bitzeilen mit Leseschaltungen ($SA_7$ - $SA_0$) zu verbinden, **dadurch gekennzeichnet, dass**

- der Adressendecoder derart angeordnet ist, dass er gleichzeitig P Bitzeilen zu M verschiedenen Spalten mit derselben partiellen Adresse auswählt, und
- der Verbindungsbus derart angeordnet ist, dass er jede der P ausgewählten Bitzeilen mit einer Leseschaltung verbindet.

**13.** Speicher nach Patentanspruch 12, **dadurch gekennzeichnet, dass** er eine Adressenabfrageschaltung (SCAN1) umfasst, die dafür eingerichtet ist, während des Lesevorganges eines Wortes die $2^N$ möglichen Kombinationen der N niederwertigen Bits ($A_0$) einer Adresse, die an den Adressendecoder angelegt ist, abzufragen.

**14.** Speicher (31, 41, MEM3, MEM4, SRAM) nach einem der Patentansprüche 10 und 11, Speicherzellen umfassend, die in Wortzeilen und in Bitzeilen angeordnet sind, wobei eine Wortzeile eine Speicherseite bildet, **dadurch gekennzeichnet, dass** er Mittel zum Verschachteln von Bits enthält, dafür eingerichtet (Tabelle 2),

- M Wörter derselben partiellen Adresse in M aneinander anschließende Unterseiten einer Speicherseite zu speichern,
- jedes Wort in P aneinander anschließende Gruppen von Zellen zu speichern, die jeweils K/P aneinander anschließende Untergruppen von Zellen umfassen, wobei K die Anzahl der Bits jedes Wortes ist, und
- Bits vom Rang j und j + 1 eines Wortes in aneinander anschließende Zellengruppen zu speichern, und Bits vom Rang j und j + P eines Wortes in aneinander anschließende Untergruppen von Zellen, derart, dass die Wörter in den Unterseiten umgefaltet sind.

**15.** Speicher (31, MEM3) nach Patentanspruch 14, einen Adressendecoder (BDEC2) enthaltend, der Schalter (TS) zur Auswahl der Bitzeile umfasst, eine Schaltung (PGRC2) zur Programmierung des Speichers, der Latches (LT) umfasst, deren Eingang an einen Datenbus (DB) mit K Leitungen angeschlossen ist, **dadurch gekennzeichnet, dass**

- die Programmierschaltung (PGRC2) M mal K Latches (LT) umfasst,
- die Bitzeilen (BL) derselben Untergruppe von Zellen (SGP) über Auswahlschalter (TS) mit einer gemeinsamen Leitung (L) verbunden sind,
- jede gemeinsame Leitung an den Ausgang eines Latch (LT) angeschlossen ist, und
- die Latches ($LT_{00}$, $LT_{40}$), deren Ausgänge an Untergruppen von Zellen desselben Ranges angeschlossen sind, die verschiedenen Unterseiten angehören, an dieselbe Leitung ($b_7$) des Datenbuses angeschlossen sind.

**16.** Speicher nach Patentanspruch 15, **dadurch gekennzeichnet, dass** der Adressendecoder (BDEC2) Inhibitionsmittel (READ) in der Betriebsart Lesen seiner N niederwertigen Adresseneingänge ($A_0$) aufweist, um gleichzeitig alle Bitzeilen auszuwählen, die den Bits aller Wörter des Speichers entsprechen, die dieselbe partielle Adresse haben.

**17.** Speicher nach Patentanspruch 16, **dadurch gekennzeichnet, dass** die gemeinsamen Zeilen der Untergruppen von Zellen ein und derselben Zellengruppe über eine Multiplexerschaltung (MUX2) mit ein und derselben Leseschaltung ($SA_7$ - $SA_0$) verbunden sind, Multiplexerschaltung, die derart eingerichtet ist, dass sie eine einzige gemeinsame Zeile auf einmal an die Leseschaltung anschließt, die durch ein Befehlssignal (AX) der Multiplexerschaltung bestimmt wird.

**18.** Speicher nach Patentanspruch 17, **dadurch gekennzeichnet, dass** das Multiplexermittel (MUX2) durch eine Abrufschaltung (SCAN2) gesteuert wird, die derart eingerichtet ist, dass sie im Verlauf eines Lesevorganges eines Wortes alle Multiplexwerte des Befehlssignals (AX) durchläuft, derart, dass die gemeinsamen Zeilen jeder Untergruppe einer Zellengruppe eine nach der anderen mit der Leseschaltung verbunden werden.

**19.** Speicher (MEM4) nach einem der Patentansprüche 10, 11, 14, einen Speicherblock (41) und Peripherieteile des Speicherblockes umfassend, **dadurch gekennzeichnet, dass** er Mittel zum Verschachteln von Bits (SRAM) enthält, die zwischen dem seriellen Eingang (DIN) und dem Eingang des Speicherblockes (41) angeordnet und dafür eingerichtet sind, an den Eingang des Speicherblockes zusammengesetzte Wörter anzulegen, die M Gruppen von P Bits von M verschiedenen Binärwörtern anlegen.

**20.** Speicher nach einem der Patentansprüche 10, 11, 14, 19, **dadurch gekennzeichnet, dass** er einen flüchtigen Pufferspeicher (SRAM) umfasst, dessen Ausgang mit dem Eingang des Speicherblockes (41) verbunden ist, und Mittel (UC) zum Einspeichern von Daten in den Pufferspeicher, die im Speicherblock gespeichert werden sollen, und dann im Speicherblock die Daten zu speichern, die vorab im Pufferspeicher gespeichert wurden.

**21.** Speicher nach Patentanspruch 20, **dadurch gekennzeichnet, dass** er Mittel (SCAN3, $SSA_7$ - $SSA_0$) zum Einspeichern von zusammengesetzten Wörtern in den Pufferspeicher enthält, die M Gruppen von P Bits von M verschiedenen Binärwörtern umfassen, die seriell empfangen wurden.

**22.** Speicher nach einem der Patentansprüche 10 bis 21, in dem P gleich K/M ist, wobei K die Anzahl an Bits ist, die die Wörter umfassen, die im Speicher gespeichert sind, wobei M gleich $2^N$ ist.

**23.** Speicher nach einem der Patentansprüche 10 bis 22, in dem N gleich 1 ist und M gleich 2.

Fig. 1

## Fig. 2

20
(EEPROM)

## Fig. 4

## Fig. 6

**Fig. 3**

**Fig. 5**

Fig. 7A    CLK

Fig. 7B    DIN    | A₃ | A₂ | A₁ | A₀ |

Fig. 7C    LRA1

Fig. 7D    SRA1

Fig. 7E    READ

Fig. 7F    LRA2

Fig. 7G    A₀'

Fig. 7H    INCR

Fig. 7I    LRS    Δt

Fig. 7J    SRS

Fig. 7K    LLTS

Fig. 7L    DOUT    | b₇ | b₆ | b₅ | b₄ | b₃ | b₂ | b₁ | b₀ |

Fig. 9

**Fig. 11**

**Fig.13**

**Fig. 14**

Fig. 15

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   EP 712133 A